# EUROPEAN PATENT APPLICATION

(11) **EP 4 542 649 A1**
(43) Date of publication of application: **23.04.2025**
(21) Application number: 22954348.3
(22) Date of filing: 09.08.2022
(51) Int. Cl.: H01L 27/00

(54) **BASE PLATE AND ELECTRONIC APPARATUS**

(71) Applicant: Boe Technology Group Co., Ltd., Beijing 100015 (CN); BOE MLED Technology Co., Ltd., Beijing 100176 (CN)
(72) Inventor: SU, Wengang, Beijing 100176 (CN); WANG, Feifei, Beijing 100176 (CN); YIN, Kaimin, Beijing 100176 (CN); ZHANG, Zhitao, Beijing 100176 (CN); GAI, Jiajia, Beijing 100176 (CN); HAO, Wei, Beijing 100176 (CN); CHA, Huangfei, Beijing 100176 (CN); SHI, Lingyun, Beijing 100176 (CN); LUO, Ningyu, Beijing 100176 (CN); XU, Zouming, Beijing 100176 (CN); WU, Xintao, Beijing 100176 (CN); WANG, Jie, Beijing 100176 (CN); XU, Jiawei, Beijing 100176 (CN); HAN, Tingwei, Beijing 100176 (CN)
(74) Representative: Hoffmann Eitle
(86) International application number: PCT/CN2022/111258
(87) International publication number: WO 2024/031372

(57) **Abstract**

A base plate, which has multiple edges. The base plate comprises a device region and at least one binding region that is close to any edge of the base plate relative to the device region. The base plate comprises a substrate, a plurality of device groups, a plurality of signal line groups and a plurality of bridging portions, wherein the plurality of device groups are located on one side of the substrate, and the plurality of device groups are located in the device region; the plurality of device groups are respectively arranged in a first direction and a second direction, the first direction intersecting the second direction, and the first direction and the second direction being parallel to the substrate; each device group comprises at least one electronic element; each signal line group comprises a plurality of signal lines; the plurality of signal lines all extend in the second direction, and are arranged at intervals in the first direction; any signal line extends from the binding region to the device region, and is electrically connected to the same column of device groups arranged in the second direction; at least one of the bridging portions is located in the device region; and at least two of the signal lines in at least one of the signal line groups are electrically connected to each other by means of the bridging portion.

## Description

### TECHNICAL FIELD

The present disclosure relates to the field of display technologies, and in particular, to a substrate and an electronic apparatus.

### BACKGROUND

A substrate usually includes electronic components and signal lines, in which the signal lines are electrically connected to the electronic components to achieve signal transmission.

### SUMMARY

In an aspect, a substrate is provided. The substrate has multiple edges. The substrate includes a device region and at least one bonding region, the bonding region being closer to any edge of the substrate relative to the device region. The substrate includes a base, a plurality of device groups, a plurality of signal line groups, and a plurality of bridging parts. The plurality of device groups are located on a side of the base, and the plurality of device groups are located in the device region. The plurality of device groups are arranged along both a first direction and a second direction, the first direction intersecting the second direction, and the first direction and the second direction being parallel to the base. A device group includes at least one electronic component. The plurality of signal line groups are located on the same side of the base as the plurality of device groups. A signal line group includes multiple signal lines, the multiple signal lines all extend along the second direction, and the multiple signal lines are arranged at intervals along the first direction. Any signal line extends from a bonding region to the device region, and any signal line is electrically connected to a column of device groups arranged along the second direction. The plurality of bridging parts are located on the same side of the base as the plurality of device groups. At least one bridging part is located in the device region. At least two signal lines in at least one signal line group are electrically connected together through a bridging part.

In some embodiments, the plurality of signal line groups include a first voltage line group, the first voltage line group including multiple first voltage lines. At least one first voltage line in the first voltage line group includes at least two first sub-portions, and the at least two first sub-portions are arranged at intervals along the second direction. The plurality of bridging parts include multiple fifth bridging parts, and a fifth bridging part is electrically connected to two adjacent first sub-portions in a same first voltage line.

In some embodiments, the plurality of signal line groups include a second voltage line group, the second voltage line group including multiple second voltage lines. At least one second voltage line in the second voltage line group includes at least two second sub-portions, and the at least two second sub-portions are arranged at intervals along the second direction. The plurality of bridging parts include multiple sixth bridging parts, and a sixth bridging part is electrically connected to two adjacent second sub-portions in a same second voltage line.

In some embodiments, the substrate further includes a plurality of conductive patterns. At least one conductive pattern in the plurality of conductive patterns is located in a region where a device group is located, and/or at least one conductive pattern in the plurality of conductive patterns is located in a region between two adjacent device groups. At least one signal line in at least one signal line group is electrically connected to a conductive pattern of the plurality of conductive patterns.

In some embodiments, the at least one signal line in the at least one signal line group is electrically connected to the bonding region through the conductive pattern.

In some embodiments, the plurality of conductive patterns include multiple first conductive patterns, and the multiple first conductive patterns are each electrically connected to at least one first voltage line in the first voltage line group.

In some embodiments, the plurality of bridging parts include multiple first bridging parts. At least one first conductive pattern is electrically connected to a first voltage line through a first bridging part.

In some embodiments, at least one first conductive pattern and a first voltage line form a one-piece structure.

In some embodiments, at least two of the first conductive patterns are arranged along the first direction.

In some embodiments, the multiple first conductive patterns include first-type first conductive pattern(s). One end of a first-type first conductive pattern is directly connected to an end of the bonding region proximate to the device region, and the other end of the first-type first conductive pattern is electrically connected to the first voltage line group; and a number of the first-type first conductive pattern(s) is a, a is less than a number of the first voltage lines in the first voltage line group, and a is a positive integer.

**In** some embodiments, the a is not greater than half of the number of the first voltage lines in the first voltage line group.

**In** some embodiments, at least two, arranged along the first direction, of the first conductive patterns form a first conductive pattern row; and at least two, arranged along the second direction, of the first conductive patterns form a first conductive pattern column; and the first conductive pattern row is electrically connected to the first conductive pattern column, and the first-type first conductive pattern is electrically connected to the first conductive pattern column.

In some embodiments, the first conductive pattern row is located at a center of the device region along the second direction.

In some embodiments, the plurality of conductive patterns include multiple second conductive patterns, and the multiple second conductive patterns are each electrically connected to at least one second voltage line in the second voltage line group.

In some embodiments, the plurality of bridging parts further include multiple second bridging parts. At least one second conductive pattern is electrically connected to a second voltage line through a second bridging part.

In some embodiments, at least one second conductive pattern and a second voltage line form a one-piece structure.

In some embodiments, at least two of the second conductive patterns are arranged along the first direction.

In some embodiments, the plurality of second conductive patterns include first-type second conductive pattern(s). One end of a first-type second conductive pattern is directly connected to an end of the bonding region proximate to the device region, and the other end of the first-type second conductive pattern is electrically connected to the second voltage line group; and a number of the first-type second conductive pattern(s) is b, b is less than a number of the second voltage lines in the first voltage line group, and b is a positive integer.

In some embodiments, the b is not greater than half of the number of the second voltage lines in the second voltage line group.

In some embodiments, the multiple second voltage lines in the second voltage line group are connected to each other on a side thereof away from the bonding region along the second direction. At least two, arranged along the second direction, of the second conductive patterns form a second conductive pattern column; and the second conductive pattern column is electrically connected to the side, away from the bonding region, of the multiple second voltage lines in the second voltage line group, and the first-type second conductive pattern is electrically connected to the second conductive pattern column.

**In** some embodiments, at least two, arranged along the second direction, of the second conductive patterns form a second conductive pattern column; and the second conductive pattern column, adjacent to an edge of the base along the first direction, overlaps with a region where a column of device groups arranged along the second direction is located.

**In** some embodiments, the plurality of bridging parts further include: multiple third bridging parts, at least two of the first conductive patterns being electrically connected together through a third bridging part; and/or multiple fourth bridging parts, at least two of the second conductive patterns being electrically connected together through a fourth bridging part.

**In** some embodiments, a first voltage line electrically connected to a column of device groups, and a second voltage line electrically connected to the column of device groups are arranged at intervals along the first direction.

In some embodiments, any first voltage line is located, along the first direction, on a first side of a column of device groups electrically connected to the first voltage line; and any second voltage line is located, along the first direction, on a second side of a column of device groups electrically connected to the second voltage line.

In some embodiments, a width of the first voltage line along the first direction takes a value in a range of 0.5 mm to 1 mm; and/or a width of the second voltage line along the first direction takes a value in a range of 0.5 mm to 1 mm.

In some embodiments, the plurality of conductive patterns disposed in a same layer as the plurality of signal line groups.

In some embodiments, at least one of the plurality of bridging parts is a jumper resistor.

In some embodiments, the substrate further includes an electrostatic loop, disposed around the plurality of device groups and electrically connected to the bonding region, and a circuit board, electrically connected to the bonding region.

In another aspect, an electronic apparatus is provided. The electronic apparatus includes the substrate as described in the above embodiments.

### BRIEF DESCRIPTION OF THE DRAWINGS

In order to describe technical solutions in the present disclosure more clearly, the accompanying drawings to be used in some embodiments of the present disclosure will be introduced briefly. It is obvious that the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1A is a structural diagram of an electronic apparatus in accordance with some embodiments;
FIG. 1B is a structural diagram of an electronic apparatus in accordance with some other embodiments;
FIG. 2A is a structural diagram of a substrate in accordance with some embodiments;
FIG. 2B is a structural diagram of a substrate in accordance with some other embodiments;
FIG. 2C is a structural diagram of a device group in accordance with some embodiments;
FIG. 2D is a structural diagram of a driving chip and device groups in accordance with some embodiments;
FIG. 2E is a structural diagram of a driving chip and device groups in accordance with some other embodiments;
FIG. 2F is a structural diagram of a substrate in accordance with yet some other embodiments;
FIG. 2G is a structural diagram of a substrate in accordance with still some other embodiments;
FIG. 3A is a structural diagram of a substrate in accordance with still yet some other embodiments;
FIG. 3B is a structural diagram of a substrate in accordance with still yet some other embodiments;
FIG. 3C is a structural diagram of a substrate in accordance with still yet some other embodiments;
FIG. 3D is a structural diagram of a substrate in accordance with still yet some other embodiments;
FIG. 3E is a structural diagram of a substrate in accordance with still yet some other embodiments;
FIG. 3F is a structural diagram of a substrate in accordance with still yet some other embodiments;
FIG. 4A is a structural diagram of a substrate in accordance with still yet some other embodiments;
FIG. 4B is a structural diagram of a substrate in accordance with still yet some other embodiments;
FIG. 4C is a structural diagram of a substrate in accordance with still yet some other embodiments;
FIG. 5A is a structural diagram of a substrate in accordance with still yet some other embodiments;
FIG. 5B is a structural diagram of a substrate in accordance with still yet some other embodiments;
FIG. 5C is a structural diagram of a substrate in accordance with still yet some other embodiments;
FIG. 5D is a structural diagram of a substrate in accordance with still yet some other embodiments;
FIG. 5E is a structural diagram of a substrate in accordance with still yet some other embodiments;
FIG. 6A is a structural diagram of a substrate in accordance with still yet some other embodiments;
FIG. 6B is a structural diagram of a substrate in accordance with still yet some other embodiments;
FIG. 6C is a structural diagram of a substrate in accordance with still yet some other embodiments;
FIG. 7A is a structural diagram of a substrate in accordance with still yet some other embodiments;
FIG. 7B is a partially enlarged view of the region 1 in FIG. 7A;
FIG. 8A is a structural diagram of a substrate in accordance with still yet some other embodiments;
FIG. 8B is a partially enlarged view of the region 2 in FIG. 8A;
FIG. 8C is a partially enlarged view of the region 3 in FIG. 8A; and
FIG. 8D is a partially enlarged view of the region 4 in FIG. 8A.

### DETAILED DESCRIPTION

The technical solutions in some embodiments of the present disclosure will be described clearly and completely with reference to the accompanying drawings. It is obvious that the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

Hereinafter, the terms "first," "second," etc., are used for descriptive purposes only, and are not to be construed as indicating or implying a relative importance or implicitly indicating a number of indicated technical features. Thus, features defined by "first" or "second" may explicitly or implicitly include one or more of the features. In the description of the embodiments of the present disclosure, the term "a plurality of" or "multiple" means two or more unless otherwise specified.

In the description of some embodiments, the terms "connected" and derivatives thereof may be used. For example, the term "connected" may be used in the description of some embodiments to indicate that two or more components are in direct physical or electrical contact with each other.

The phrase "at least one of A, B and C" has the same meaning as the phrase "at least one of A, B or C," and they both include the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

The term such as "about," "substantially," or "approximately" as used herein includes a stated value and an average value within an acceptable range of deviation of a particular value. The acceptable range of deviation is determined by a person of ordinary skill in the art, considering measurement in question and errors associated with measurement of a particular quantity (i.e., limitations of a measurement system).

The term such as "parallel," "perpendicular," or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, that a difference between two equals is less than or equal to 5% of either of the two equals.

It will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views that are schematic illustrations of idealized embodiments. In the accompanying drawings, thicknesses of layers and areas of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in a device, and are not intended to limit the scope of the exemplary embodiments.

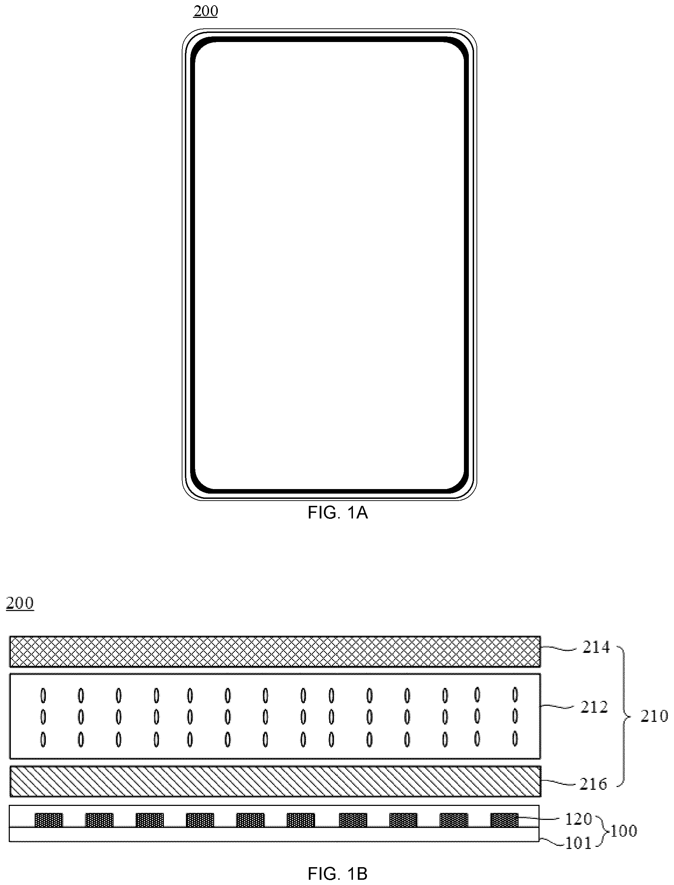

FIG. 1A is a structural diagram of an electronic apparatus in accordance with some embodiments.

As shown in FIG. 1A, embodiments of the present disclosure provide an electronic apparatus 200. In some examples, the electronic apparatus 200 may be a product having an image display function. For example, the electronic apparatus 200 may be used for displaying a static image, such as a picture or a photograph. The electronic apparatus 200 may also be used for displaying dynamic images, such as videos or game screens.

In some examples, the electronic apparatus 200 may be a notebook computer, a mobile telephone, a wireless device, a personal digital assistant (PDA), a hand-held or portable computer, a global positioning system (GPS) receiver/navigator, a camera, an MPEG-4 Part 14 (MP4) video player, a video camera, a game console, a watch, a clock, a calculator, a television monitor, a flat-panel display, a computer monitor, a car display (e.g., an odometer display), a navigator, a cockpit controller and/or display, a camera view display (e.g., a rear view camera display in a vehicle), an electronic photo, an electronic billboard or sign, a projector, a packaging and aesthetic structure (e.g., a display for displaying an image of a piece of jewelry), or the like.

In some other examples, the electronic apparatus 200 may be a product without image display function.

The embodiments of the present disclosure do not limit the electronic apparatus 200 further, and the following is an example of the electronic apparatus 200 as a product having an image display function.

FIG. 1B is a structural diagram of an electronic apparatus in accordance with some other embodiments.

As shown in FIG. 1B, in some embodiments, the electronic apparatus 200 may include a substrate 100 and a display panel 210. For example, the substrate 100 is used for emitting light outwardly, and the display panel 210 is located on a light-exit side of the substrate 100 for displaying image information.

In some examples, the display panel 210 is a liquid crystal display panel, and the substrate 100 is used for providing a backlight to the display panel 210.

In some examples, the substrate 100 may be used for emitting white light or blue light. The display panel 210 is able to filter or convert the light emitted by the substrate 100 to obtain red light, green light, and blue light, enabling the electronic apparatus 200 to achieve a full-color image display.

The display panel 210 will be described below by taking the display panel 210 as a liquid crystal display panel as an example.

In some examples, as shown in FIG. 1B, the display panel 210 includes an array substrate 216, an opposite substrate 214, and a liquid crystal layer 212 disposed between the array substrate 216 and the opposite substrate 214. It can be understood that the light emitted by the substrate 100 is able to pass through the array substrate 216 and irradiate the liquid crystal layer 212. The liquid crystal layer 212 includes liquid crystal molecules. By controlling the deflection angle of the liquid crystal molecules, it is possible to play a role in controlling the intensity of the light that passes through the liquid crystal layer 212 and irradiates the opposite substrate 214, thereby enabling the electronic apparatus 200 to realize an image display function.

In some examples, in a case where the substrate 100 is used for emitting white light, the opposite substrate 214 may include red filter films, green filter films, and blue filter films. By controlling the intensities of light irradiated to the red filter films, the green filter films, and the blue filter films, it is possible to obtain different intensities of red light, green light, and blue light, enabling the electronic apparatus 200 to display color images.

In some other examples, in a case where the substrate 100 is used for emitting blue light, the opposite substrate 214 may include color conversion films. For example, the color conversion films may be quantum dot films. Some blue light can be converted to red light after irradiating to red quantum dot films, and some blue light can be converted to green light after irradiating to green quantum dot films. The red light and the green light, which are obtained after conversion of the quantum dot films, are mixed with the blue light emitted by the substrate 100, enabling the electronic apparatus 200 to realize a full-color image display.

In some examples, the display panel 210 includes a common electrode and a plurality of pixel electrodes. An electric field can be formed between the common electrode and each pixel electrode. By controlling a voltage value of each pixel electrode, it is possible to control the strength of the electric field formed between the common electrode and each pixel electrode, thereby controlling the deflection angle of the liquid crystal molecules in the liquid crystal layer 212, i.e., controlling the intensity of the light passing through the liquid crystal layer 212.

In some examples, the pixel electrodes may be disposed in the array substrate 216, and the common electrode may be disposed in the array substrate 216 or the opposite substrate 214.

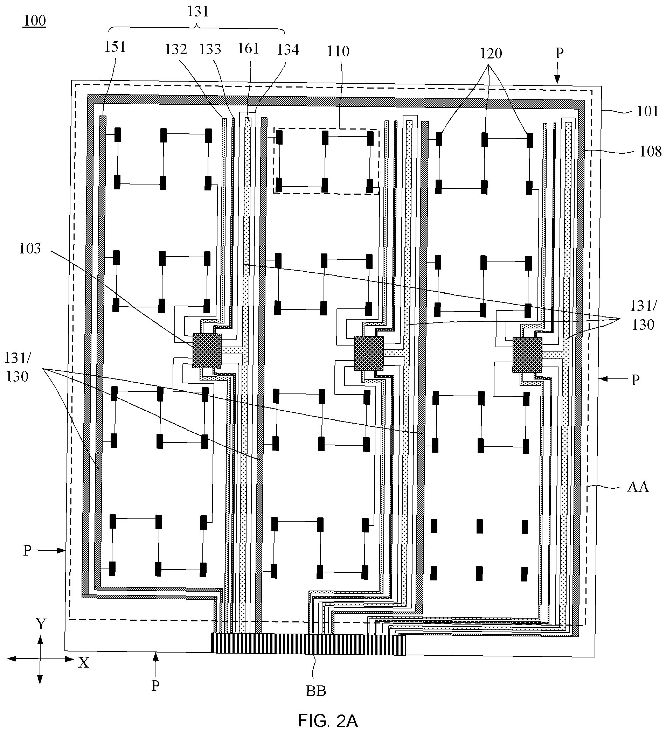

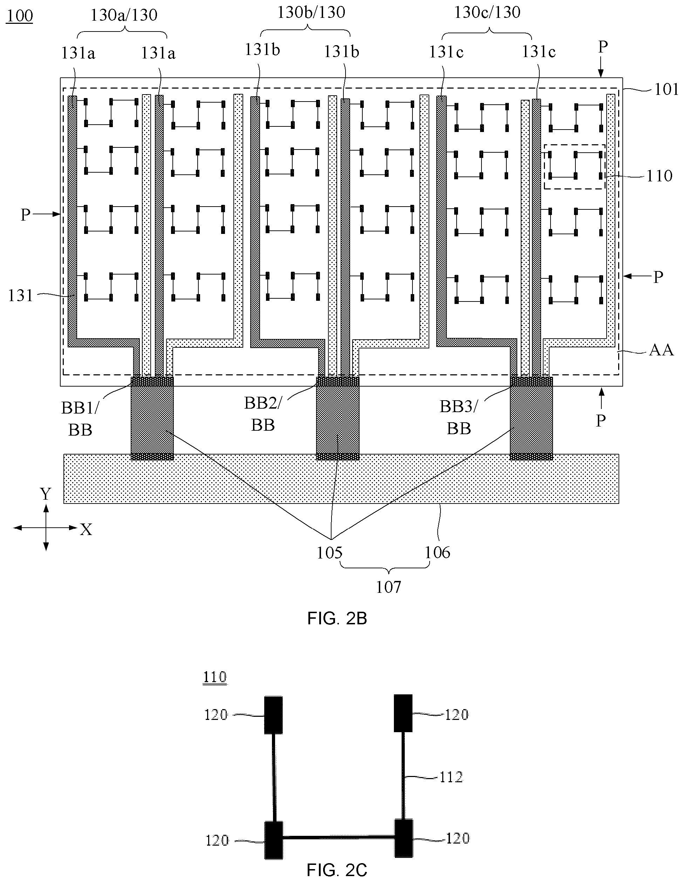

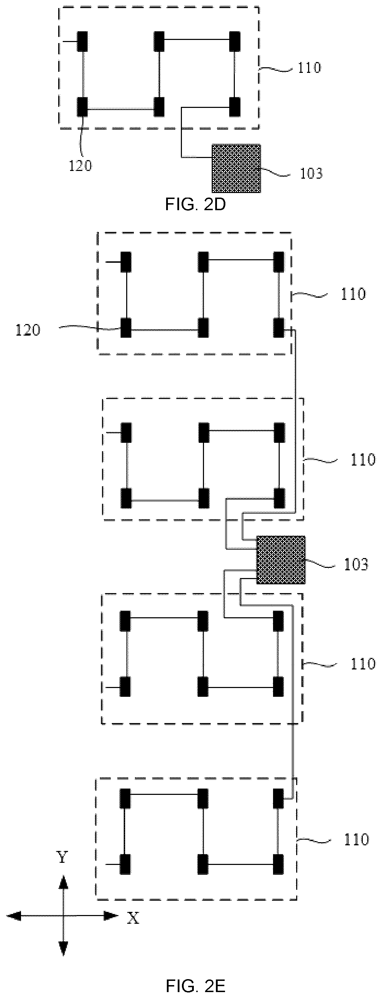

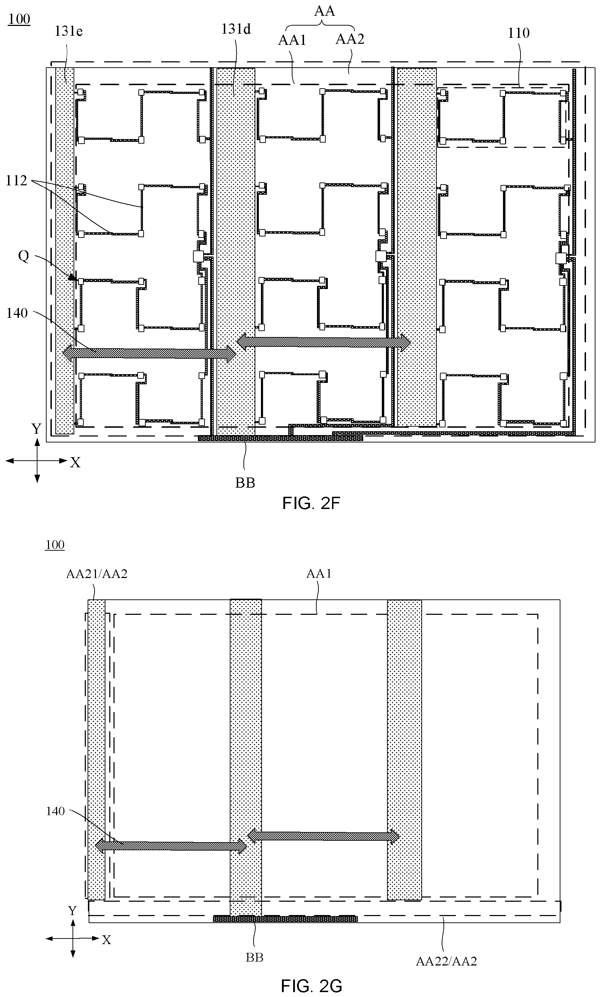

FIG. 2A is a structural diagram of a substrate in accordance with some embodiments. FIG. 2B is a structural diagram of a substrate in accordance with some other embodiments. FIG. 2C is a structural diagram of a device group in accordance with some embodiments. FIG. 2D is a structural diagram of a driving chip and device groups in accordance with some embodiments. FIG. 2E is a structural diagram of a driving chip and device groups in accordance with some other embodiments. FIG. 2F is a structural diagram of a substrate in accordance with yet some other embodiments. FIG. 2G is a structural diagram of a substrate in accordance with still some other embodiments. The following refers to FIG. 2A to FIG. 2G to illustrate the substrate 100 as an example.

In some embodiments, as shown in FIG. 2A and FIG. 2B, the substrate 100 has multiple edges P. It can be understood that an edge P of the substrate 100 may be in the shape of a straight segment or a curved segment. In some examples, as shown in FIG. 2A and FIG. 2B, the substrate 100 may be in the shape of a square or a rectangle, i.e., the substrate 100 may have four edges P.

In some other examples, the substrate 100 may be in the shape of a polygon or any of other irregular shapes. Embodiments of the present disclosure do not further limit the shape of the substrate 100, and the number of the edges P that the substrate 100 has.

As shown in FIG. 2A and FIG. 2B, the substrate 100 includes a device region AA and at least one bonding region BB. The bonding region BB is closer to any edge P of the substrate 100 relative to the device region AA.

It can be understood that an edge of the bonding region BB at a side thereof proximate to the device region AA is adjacent to an edge of the device region AA at a side thereof proximate to the bonding region BB. It will be noted that in the accompanying drawings of the present disclosure, taking FIG. 2A and FIG. 2B as examples, the edge of the device region AA shown in the dotted box and the edge of the bonding region BB are disposed at intervals from each other merely for the purpose of clearly differentiating the device region AA from the bonding region BB, and not to further qualify the positions of the edges of the device region AA and the bonding region BB.

The bonding region BB is closer to any edge P of the substrate 100 relative to the device region AA. That is, the bonding region BB may be located between the device region AA and any edge P.

In some examples, the bonding region BB is disposed on a side of the device region AA along the second direction Y. For example, the second direction Y may be a vertical direction.

In some examples, as shown in FIG. 2A, there may be one bonding region BB. In some other examples, as shown in FIG. 2B, there may be multiple bonding regions BB. For example, the number of the bonding regions BB may be two, three or four.

It can be understood that as shown in FIG. 2B, in a case where there are multiple bonding regions BB, the multiple bonding regions BB are located on the same side of the device region AA, that is, the multiple bonding regions BB are arranged at the same edge P.

In some examples, as shown in FIG. 2B, the multiple bonding regions BB may be arranged at intervals along the first direction X. For example, the first direction X may be a horizontal direction, and the first direction X may be perpendicular to the second direction Y. It can be understood that the multiple bonding regions BB may be arranged at the same distance spacing, or any two adjacent bonding regions BB of the multiple bonding regions BB may have a different spacing distance therebetween.

As shown in FIG. 2A and FIG. 2B, the substrate 100 includes a base 101 and a plurality of device groups 110. The plurality of device groups 110 are disposed on a side of the base 101, and the plurality of device groups 110 are disposed in the device region AA. The plurality of device groups 110 are arranged along the first direction X and the second direction Y, where the first direction X and the second direction Y intersect and the first direction X and the second direction Y are parallel to the base 101. A device group 110 includes at least one electronic component 120.

In some examples, the base 101 may be a rigid base. In some other examples, the base 101 may be a flexible base. For example, the material of the base 101 includes any one of plastic, flame retardant 4 level (FR-4 level) material, resin, glass, quartz, polyimide (PI), and polymethyl methacrylate (PMMA).

It can be understood that the plurality of device groups 110 are located on the same side of the base 101 and are located in the device region AA. In some examples, the plurality of device groups 110 are arranged at intervals along the first direction X, and along the first direction X, the spacing between two adjacent device groups 110 is the same or approximately the same; and the plurality of device groups 110 are arranged at intervals along the second direction Y, and along the second direction Y, the spacing between two adjacent device groups 110 are the same or approximately the same. In this way, as shown in FIG. 2A and FIG. 2B, multiple device groups 110 are enabled to be arranged in a row along the first direction X, and multiple device groups 110 are enabled to be arranged in a column along the second direction Y. It can be understood that multiple rows of device groups 110 are arranged at intervals along the second direction Y, and multiple columns of device groups 110 are arranged at intervals along the first direction X.

It will be noted that in the accompanying drawings of the specification of the present disclosure, only device groups 110 in four rows and three columns (e.g., in FIG. 2A), or device groups 110 in four rows and six columns (e.g., in FIG. 2B) are shown for the purpose of clearly showing the structure of the substrate 100, and the number of the device groups 110 and the arrangement manner thereof in the embodiments of the present disclosure will not be further limited.

It can be understood that a device group 110 may include one electronic component 120 or multiple electronic components 120.

In some examples, in a case where a device group 110 includes multiple electronic components 120, the multiple electronic components 120 may be components of the same type or components of different types. For example, in a case where the substrate 100 is used for emitting light, an electronic component 120 may be a light-emitting device. Multiple light-emitting devices included in a device group 110 may be used for emitting light of the same color, or multiple light-emitting devices included in a device group 110 may be used for emitting light of multiple different colors. Alternatively, among multiple electronic components 120 included in a device group 110, some (one or more) are light-emitting devices for emitting light, while the other (one or more) are other components (such as sensor chips) to implement other functions.

In some examples, as shown in FIG. 2A and FIG. 2B, a device group 110 may include six electronic components 120. In some other examples, as shown in FIG. 2C, a device group 110 may include four electronic components 120. In still some other examples, a device group 110 may include two, three or five electronic components 120. It can be understood that different device groups 110 may each include the same or different number of electronic components 120. The embodiments of the present disclosure do not further limit the number of electronic components 120 in a device group 110.

In some examples, as shown in FIG. 2A and FIG. 2B, in a case where a device group 110 includes multiple electronic components 120, the multiple electronic components 120 may be arranged in a matrix, that is, the multiple electronic components 120 may be arranged at the four vertices of a rectangle or a square, improving the regularity of the arrangement of the multiple electronic components 120.

In some other examples, in a case where a device group 110 includes multiple electronic components 120, the multiple electronic components 120 in the device group 110 may be arranged at the vertices of a hexagon, an octagon, or any one of other irregular shapes, alternatively, the multiple electronic components 120 in the device group 110 may be arranged as a circle or an ellipse, etc., to satisfy different usage requirements.

In some examples, as shown in FIG. 2C, multiple electronic components 120 in a device group 110 are electrically connected together through connection lines 112.

For example, multiple electronic components 120 in a device group 110 may be connected in series through connection lines 112. In this way, providing an electrical signal to any one electronic component 120 in this device group 110 enables the provision of the electrical signal to each electronic component 120 in this device group 110, improving the ease of the wiring of the substrate 100.

As can be seen from the above, in some examples, the substrate 100 may be used for providing a light source. In this case, the electronic component 120 may be a light-emitting device. For example, the electronic component 120 is a light-emitting diode (LED).

In some examples, the electronic component 120 may be any one of a conventional LED, a sub-millimeter light-emitting diode (Mini LED), and a micro light-emitting diode (Micro LED).

For example, the conventional LED is an LED of the size greater than or equal to 500 µm; the Mini LED is an LED of the size greater than or equal to 100 µm and less than 500 µm; and the Micro LED is an LED of the size less than 100 µm. In some examples, the size of the Micro LED may be less than or equal to 50 µm.

In some examples, the electronic components 120 in all the device groups 110 may be used for emitting light of the same color. For example, the electronic components 120 in all the device groups 110 are all used for emitting white light, alternatively, the electronic components 120 in all the device groups 110 are all used for emitting blue light. In this way, the substrate 100 is able to emit light of a specific color.

In some examples, each electronic component 120 in a device group 110 has the same luminous brightness. Electronic components 120 in different device groups 110 may have the same or different luminous brightness. By controlling the luminous brightness of the electronic components 120 in different device groups 110, the brightness of different regions of the substrate 100 can be controlled to meet different usage requirements.

As can be seen from the above, in some embodiments, the electronic apparatus 200 includes the substrate 100 and the display panel 210. In this case, the substrate 100 may be used for providing a light source. In some other embodiments, the electronic apparatus 200 may not include the display panel 210, but only the substrate 100. In this case, the substrate 100 is used for displaying image information, and the electronic components 120 in all the device groups 110 may emit light of different colors.

For example, in a case where the substrate 100 is used for displaying image information, a part (one or more) of all the device groups 110 is used for emitting red light, another part (one or more) of all the device groups 110 is used for emitting green light, and yet another part (one or more) of all the device groups 110 is used for emitting blue light. By controlling the luminous intensities of electronic components 120 in different device groups 110, it is possible to obtain red light, green light, and blue light of different intensities, enabling the electronic apparatus 200 to realize a full-color image display.

The embodiments of the present disclosure are illustrated by way of example in which the substrate 100 employs glass as the base 101 and employs Mini LEDs as the electronic components 120, and the substrate 100 serves as a light source providing component of the electronic apparatus 200.

In some examples, as shown in FIG. 2A and FIG. 2B, the substrate 100 further includes a plurality of signal line groups 130. The plurality of signal line groups 130 are located on the same side of the base 101 as the plurality of device groups 110. A signal line group 130 includes multiple signal lines 131. The multiple signal lines 131 all extend along the second direction Y, and the multiple signal lines 131 are arranged at intervals along the first direction X. Any signal line 131 extends from a bonding region BB to the device region AA, and any signal line 131 is electrically connected to a column of device groups 110 arranged along the second direction Y.

It can be understood that the multiple signal lines 131 do not have identical lengths. A part of the signal lines has a length along the second direction Y substantially equal to a length of the column of device groups along the second direction Y, and the other part of the signal lines has a length along the second direction Y less than the length of the column of device groups along the second direction Y.

It can be understood that the plurality of signal line groups 130 are located on the same side of the base 101 as the plurality of device groups 110, enabling the signal lines 131 in the signal line groups 130 to be electrically connected to the device groups 110.

In some examples, the plurality of signal line groups 130 are disposed in the same layer, that is, the plurality of signal line groups 130 are disposed in the same conductive layer. It can be understood that the conductive layer may be provided therein with other lines in addition to the plurality of signal line groups 130.

In some other examples, the signal lines 131 in the plurality of signal line groups 130 may be disposed in different conductive layers. For example, the signal lines 131 in the plurality of signal line groups 130 may be disposed in two conductive layers.

It can be understood that the plurality of signal line groups 130 are disposed in different conductive layers, allowing greater flexibility in the wiring of the signal lines 131. However, two signal lines 131 disposed in different conductive layers are prone to short-circuiting if there is an overlap of their orthographic projections on the base 101, affecting the yield of the substrate 100. Moreover, the substrate 100 includes at least two conductive layers, which will also increase steps of manufacturing the substrate 100 and increase the production cost of the substrate 100.

It can be understood that the plurality of signal line groups 130 are disposed in the same layer, to reduce steps of patterning the conductive layers, thereby simplifying the process of manufacturing the substrate 100, reducing the number of masks, lowering the cost of the substrate 100, and also reducing the occurrence of defective failures such as short circuit of the substrate 100 so as to improve the yield rate of the substrate 100.

The embodiments of the present disclosure are illustrated by way of example in which the plurality of signal line groups 130 are disposed in the same layer.

In some examples, the substrate 100 includes an insulating layer. The insulating layer is located on a side of a conductive layer away from the base 101 and covers the conductive layer. That is, the insulating layer is able to cover the plurality of signal line groups 130 disposed in the conductive layer and other conductive structures disposed in the conductive layer.

A signal line group 130 includes multiple signal lines 131. It can be understood that the signal lines 131 are used for transmitting signals, such as analog electrical signals or digital electrical signals. In some examples, the plurality of signal line groups 130 may be used for transmitting different signals or may be used for transmitting the same signal. Each signal line 131 in a signal line group 130 is used for transmitting the same signal.

In some examples, the signal line 131 is made of metal or metal alloy. For example, the material of the signal line 131 may include copper or aluminum, to improve the electrical conductivity of the signal line 131.

In some examples, each signal line group 130 may include signal lines 131 of the same number or a different number. Any two adjacent signal lines 131 in a signal line group 130 arranged along the first direction X may have the same or different spacing therebetween.

In some examples, the bonding region BB is provided with bonding pin(s) (not shown in the figures). There may be a plurality of bonding pins, in which the plurality of bonding pins are arranged at intervals along the first direction X, and a signal line 131 is electrically connected to a bonding pin in the bonding region BB.

For example, as shown in FIG. 2A and FIG. 2B, one end of any signal line 131 is electrically connected to a bonding pin in the bonding region BB, and the other end extends from the bonding region BB to the device region AA along the second direction Y (or along both the first direction X and the second direction Y), and is electrically connected to a column of device groups 110 arranged along the second direction Y. It can be understood that the signal line 131 may be electrically connected directly to the electronic components 120 in the device groups 110, or may be electrically connected to the electronic components 120 in the device groups 110 through other component(s) or conductive pattern(s).

In some examples, at least one signal line 131 is disposed between two rows of device groups 110 spaced apart along the first direction X to improve the area utilization of the base 101.

In some examples, as shown in FIG. 2A, there is one bonding region BB, and multiple bonding pins are disposed in the bonding region BB. For example, different signal line groups 130 are electrically connected to different bonding pins to reduce mutual interference during signal transmission. Multiple signal lines 131 in the same signal line group 130 may be electrically connected to one bonding pin, or may be electrically connected to multiple bonding pins.

In some examples, in a case where there is one bonding region BB, the number of signal lines 131 in a signal line group 130 is the same as the number of columns in which the device groups 110 are arranged. That is, as shown in FIG. 2A, in a case where the plurality of device groups 110 are arranged in three columns along the second direction Y, a signal line group 130 includes three signal lines 131. It can be understood that the three signal lines 131 in the signal line group 130 may be electrically connected to three bonding pins, respectively, or may be electrically connected to one bonding pin.

In some other examples, as shown in FIG. 2B, there are multiple bonding regions BB, and multiple signal lines 131 in a signal line group 130 are electrically connected to one of the multiple bonding regions BB.

For example, as shown in FIG. 2B, the signal line groups 130 include a first signal line group 130a, a second signal line group 130b, and a third signal line group 130c. The first signal line group 130a includes first signal lines 131a, the second signal line group 130b includes second signal lines 131b, and the third signal line group 130c includes third signal lines 131c.

It will be noted that the first signal line group 130a, the second signal line group 130b, and the third signal line group 130c are only used to differentiate between the three signal line groups 130 connected to different bonding regions BB, without further limiting the signal line groups 130. The first signal lines 131a, the second signal lines 131b, and the third signal line groups 130c are used only to differentiate between the signal lines 131 in the first signal line group 130a, the signal lines 131 in the second signal line group 130b, and the signal lines 131 in the third signal line group 130c, without further limiting the signal lines 131.

In some examples, the first signal line group 130a, the second signal line group 130b, and the third signal line group 130c are used for transmitting the same signal.

For example, as shown in FIG. 2B, the bonding regions BB include a first bonding region BB1, a second bonding region BB2, and a third bonding region BB3. It will be noted that the first bonding region BB1, the second bonding region BB2, and the third bonding region BB3 are only used to differentiate between the three different bonding regions BB, without further limiting the bonding regions BB.

For example, as shown in FIG. 2B, multiple first signal lines 131a in the first signal line group 130a are electrically connected to bonding pins in the first bonding region BB1; multiple second signal lines 131b in the second signal line group 130b are electrically connected to bonding pins in the second bonding region BB2; and multiple third signal lines 131c in the third signal line group 130c are electrically connected to bonding pins in the third bonding region BB3. In this way, multiple signal lines 131 in a signal line group 130 are enabled to be electrically connected to one of the multiple bonding regions BB.

Such a setting makes different bonding regions BB transmit signals to different signal line groups 130, reduces mutual interference generated during signal transmission, and improves the reliability of the substrate 100.

In some examples, as shown in FIG. 2B, signal lines 131 (e.g., the first signal lines 131a) in a signal line group 130 (e.g., the first signal line group 130a) are electrically connected to bonding pins in a bonding region BB (e.g., the first bonding region BB1) proximate to the signal line group 130, so as to reduce the lengths of the signal lines 131, reduce the voltage drop of the signal lines 131, and improve the reliability of signal transmission. Moreover, it is further possible to reduce the amount of material used for the signal lines 131, thereby lowering the cost of the substrate 100.

In some examples, as shown in FIG. 2A, the substrate 100 further includes first driving chips 103, where a first driving chip 103 is electrically connected to at least one device group 110. That is, in some examples, as shown in FIG. 2D, a first driving chip 103 is electrically connected to only one device group 110. In some other examples, as shown in FIG. 2E, a first driving chip 103 is electrically connected to four device groups 110 arranged in sequence along the second direction Y.

It can be understood that a signal line 131 may be electrically connected to a first driving chip 103, or to one or more device groups 110.

In some examples, multiple device groups 110 arranged along the second direction Y are electrically connected to one first driving chip 103. In some other examples, multiple device groups 110 arranged along the second direction Y are electrically connected to multiple first driving chips 103, respectively. For example, in a case where multiple device groups 110 arranged along the second direction Y are electrically connected to multiple first driving chips 103, respectively, the multiple first driving chips 103 electrically connected to these device groups 110 in a column are arranged at intervals along the second direction Y.

In some examples, as shown in FIG. 2F and FIG. 2G, the device region AA includes a central region AA1 and edge region(s) AA2, where the edge region(s) AA2 surround the central region AA1. The plurality of device groups 110 are located in the central region AA1, a part (one or more) of the signal lines 131 may be located only in the edge region(s) AA2, and the other part (one or more) of the signal lines 131 may be located in the edge region(s) AA2 and the central region AA1. It can be understood that some of the components and other signal lines in the substrate have been omitted in FIG. 2F and FIG. 2G to clearly illustrate the positional relationship of a signal line group and a bridging part.

As shown in FIG. 2G, an edge region AA2, which is located between the central region AA1 and the bonding region BB along the second direction Y, may be defined as a lower edge region AA22; and two edge regions, which are adjacent to the lower edge region AA22 along the second direction Y and located on two sides of the central region AA along the first direction X may be defined as side edge regions AA21. That is, the edge region(s) AA2 include the side edge regions AA21 and the lower edge region AA22. For example, the lower edge region AA22 may also be referred to as a fanout region.

For example, as shown in FIG. 2F and FIG. 2G, the signal lines 131 extend through the bonding region BB to the lower edge region AA22 along the second direction Y (or along the first direction X and the second direction Y). A part (one or more such as a fifth signal line 131e shown in FIG. 2F) of the signal lines 131 extends from the lower edge region AA22 to a side edge region AA21, and is electrically connected to a column of device groups 110. That is, the fifth signal line 131e is located in the edge regions AA2. Another part (one or more such as a fourth signal line 131d shown in FIG. 2F) of the signal lines 131 extends from the lower edge region AA22 to the device region AA, and is electrically connected to a column of device groups 110.

It will be noted that in the embodiments of the present disclosure, the fourth signal line 131d and the fifth signal line 131e are only used to differentiate a signal line 131, which is located in the device region AA and electrically connected to the device groups 110, from a signal line 131, which is located in the side edge region AA21 and electrically connected to device groups 110, without further limiting the signal line 131.

Since the length of the signal line 131 along the second direction Y is related to the length dimension of the substrate 100 along the second direction Y, in some implementations, in order to minimize the own voltage drop (IR Drop) of the signal line 131, the resistance of the signal line 131 can be reduced by way of increasing the width of the signal line 131 along the first direction X, or increasing the thickness of the signal line 131.

For example, taking a substrate 100 of 55-inch as an example, the width of the side edge region AA21 along the first direction X is about 4.125 mm, and the width of the lower edge region AA22 along the second direction Y is about 4.62 mm. In order to make the voltage drop of the signal line 131 satisfy the demands, the width of a part (one or more) of the signal lines 131 along the first direction X needs to be set in a range of 2 mm to 15 mm.

For example, as shown in FIG. 2F, the width of the fifth signal line 131e along the first direction X needs to be greater than 3 mm (e.g., greater than 3.5 mm). In general, the side edge region AA21 is provided therein with other signal lines 131 in addition to the fifth signal line 131e. That is, increasing the width of the signal line 131 along the first direction X to reduce the voltage drop will result in more difficulty in wiring in the side edge region AA21, and result in an increase in the width of the side edge region AA21 along the first direction X, which is not conducive to realizing a narrow frame of the substrate 100.

Moreover, increasing the thickness of the signal line 131 to reduce the voltage drop will increase the amount of the material used for the signal line 131 and increase the cost of manufacturing the substrate 100.

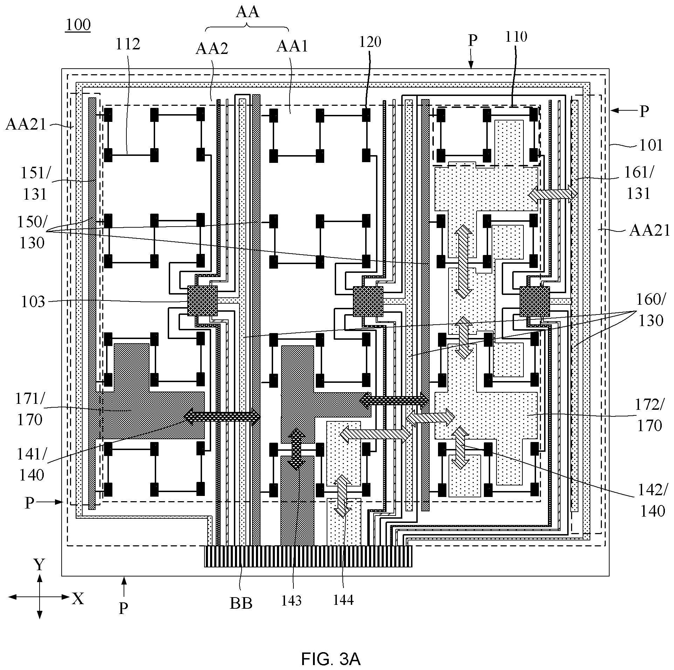

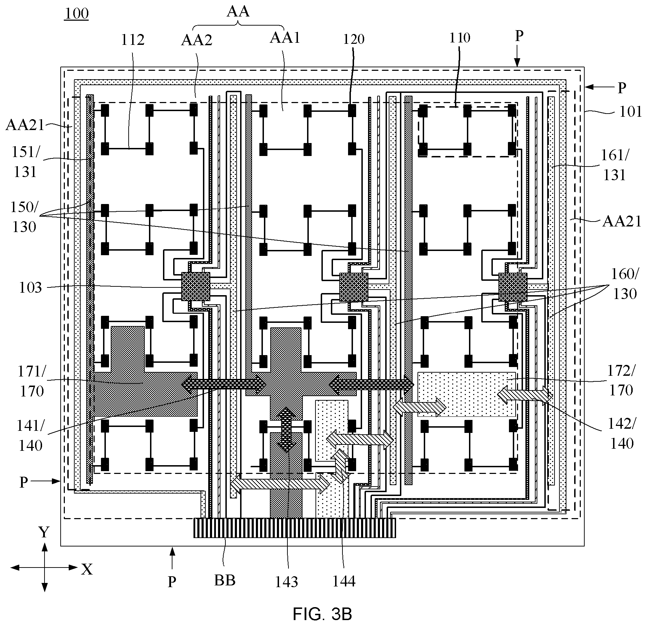

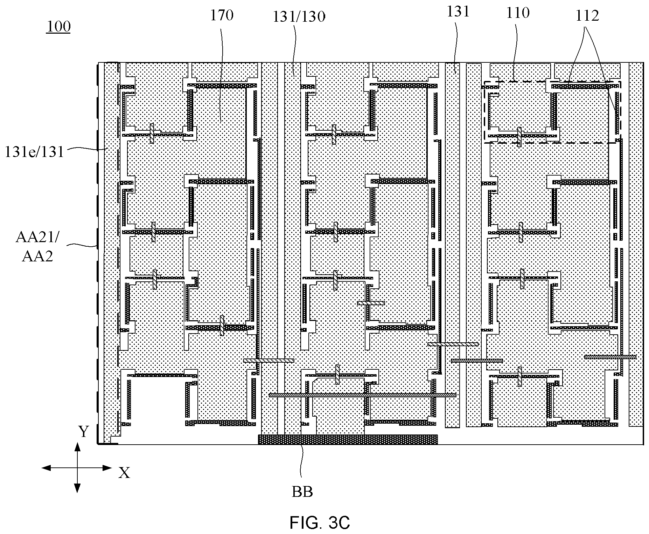

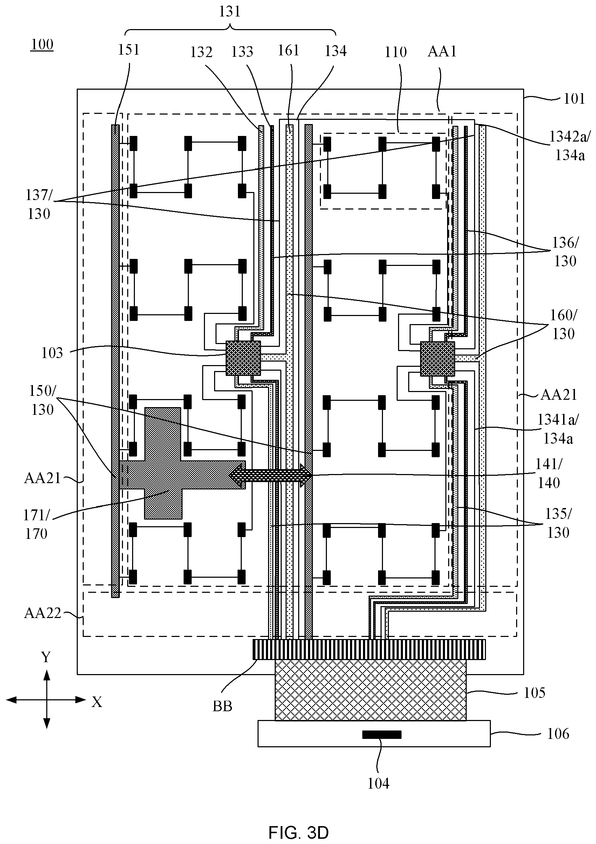

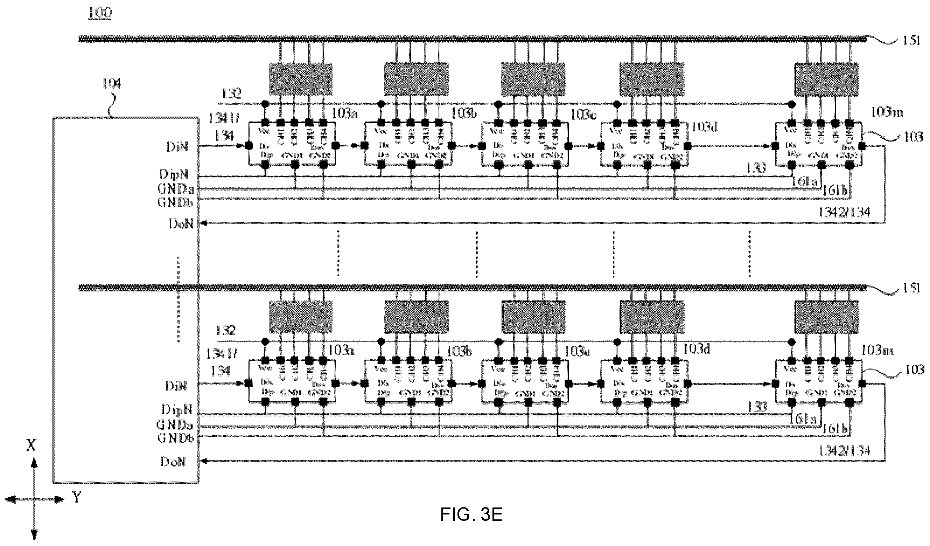

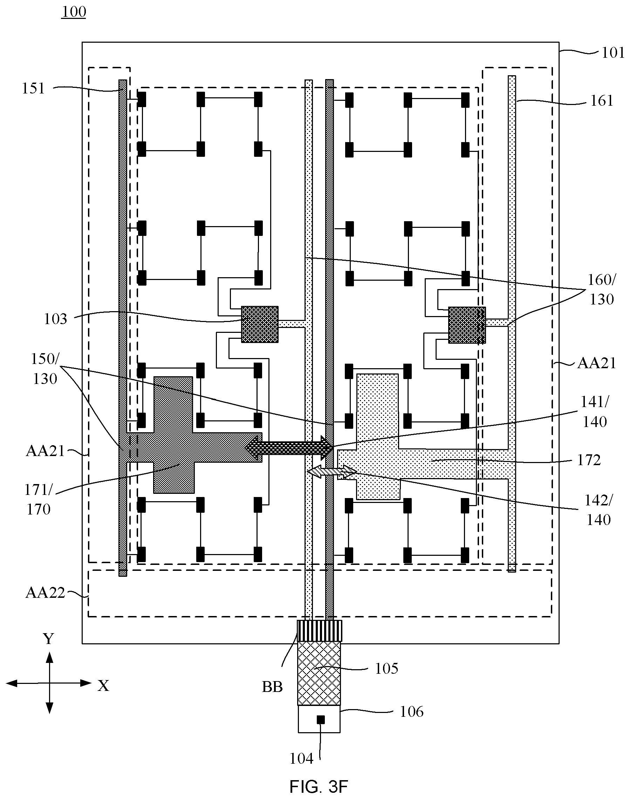

FIG. 3A is a structural diagram of a substrate in accordance with still yet some other embodiments. FIG. 3B is a structural diagram of a substrate in accordance with still yet some other embodiments. FIG. 3C is a structural diagram of a substrate in accordance with still yet some other embodiments. FIG. 3D is a structural diagram of a substrate in accordance with still yet some other embodiments. FIG. 3E is a structural diagram of a substrate in accordance with still yet some other embodiments. FIG. 3F is a structural diagram of a substrate in accordance with still yet some other embodiments.

Based on this, as shown in FIG. 3A to FIG. 3F, in the embodiments of the present disclosure, in addition to the base 101, the plurality of device groups 110 and the plurality of signal line groups 130, the substrate 100 further includes a plurality of conductive patterns 170. It can be understood that the base 101, the plurality of device groups 110 and the plurality of signal line groups 130 have been illustrated in the above-mentioned embodiments of the present disclosure, and details are not repeated here. Referring to FIG. 3A to FIG. 3F, the plurality of conductive patterns 170 will be exemplarily described below.

In some examples, as shown in FIG. 3A and FIG. 3B, the plurality of conductive patterns 170 are located on the same side of the base 101 as the plurality of device groups 110. At least one conductive pattern 170 in the plurality of conductive patterns 170 is located in a region where a device group 110 is located, and/or at least one conductive pattern 170 in the plurality of conductive patterns 170 is located in a region between two adjacent device groups 110. Here, at least one signal line 131 in at least one signal line group 130 is electrically connected to a conductive pattern 170.

It can be understood that a device group 110 includes multiple electronic components 120, and a region where the device group 110 is located refers to a closed virtual region formed by connecting boundaries of the outermost electronic components 120 in the device group in a clockwise or counterclockwise direction. In some examples, in a case where multiple electronic components 120 in a device group 110 are arranged in a matrix, a region where the device group 110 is located is rectangular, and the multiple electronic components 120 in the device group 110 are all located in the rectangular region.

In some other examples, in a case where a device group 110 includes only one electronic component 120, a region where the device group 110 is located is a rectangular region surrounding the electronic component 120.

It can be understood that the conductive pattern 170 is able to conduct electricity. In some examples, the material of the conductive pattern 170 includes copper or aluminum to enhance the conductivity of the conductive pattern 170. For example, the conductive pattern 170 may be rectangular, convex polygonal, or any of other irregular shapes. The shape of each conductive pattern 170 may be the same or different.

The plurality of conductive patterns 170 are located on the same side of the base 101 as the plurality of device groups 110. As can be seen from the above, the plurality of signal line groups 130 are also located on the same side of the base 101 as the plurality of device groups 110. That is, the plurality of conductive patterns 170, the plurality of signal line groups 130, and the plurality of device groups 110 are all located on the same side of the base 101. In this way, the conductive pattern 170 is enabled to be electrically connected to the signal line 131.

In some examples, the plurality of conductive patterns 170 may be disposed in the same layer as the plurality of signal line groups 130, so as to simplify the process of manufacturing the substrate 100 and lower the cost of manufacturing the substrate 100. In some other examples, the plurality of conductive patterns 170 and the plurality of signal line groups 130 may be disposed in different layers to reduce mutual interference between the two.

In some examples, the plurality of conductive patterns 170 are all located in the device region AA. In some other examples, the plurality of conductive patterns 170 are located in the device region AA and the bonding region BB.

In some examples, as shown in FIG. 3A and FIG. 3B, at least one conductive pattern 170 in the plurality of conductive patterns 170 is located in a region where a device group 110 is located.

In some examples, as shown in FIG. 3A and FIG. 3B, at least one conductive pattern 170 in the plurality of conductive patterns 170 may be located in a region between two adjacent device groups 110. For example, at least one conductive pattern 170 may be located in a region between two adjacent device groups 110 along the second direction Y, and at least one conductive pattern 170 may be located in a region between two adjacent device groups 110 along the first direction X.

It can be understood that as shown in FIG. 3A and FIG. 3B, any conductive pattern 170 can avoid the electronic component 120, the connection line 112 electrically connecting two adjacent electronic components 120, and the plurality of signal line groups 130. That is, an orthographic projection of the conductive pattern 170 on the base 101 is located outside a range of an orthographic projection of the electronic component 120 on the base 101, an orthographic projection of the connection line 112 on the base 101, and orthographic projections of the plurality of signal line groups 130 on the base 101. Such a setting can reduce the mutual interference between the conductive pattern 170 and both the device groups 110 and the signal line groups 130, improving the reliability of the substrate 100.

It can be understood that since at least one conductive pattern 170 is located in a region where a device group 110 is located, and/or at least one conductive pattern 170 is located in a region between two adjacent device groups 110, at least one signal line 131 in at least one signal line group 130 is enabled to be electrically connected to a conductive pattern 170.

In some examples, as shown in FIG. 3C, each signal line 131 in each signal line group 130 is electrically connected to a conductive pattern 170. In some other examples, one signal line 131 in each signal line group 130 is electrically connected to a conductive pattern 170. In still some other examples, one signal line 131 in one signal line group 130 is electrically connected to a conductive pattern 170. It can be understood that the conductive pattern 170 may be electrically connected to the signal line 131 directly, or may be electrically connected through any of other components or lines to the signal line 131.

In some examples, as shown in FIG. 3A and FIG. 3B, at least two signal lines 131 in the same signal line group 130 may be electrically connected to the same conductive pattern 170. It can be understood that signal lines 131 in different signal line groups 130 are electrically connected to different conductive patterns 170.

It can be understood that since the conductive pattern 170 is able to conduct electricity, arranging at least one signal line 131 in at least one signal line group 130 electrically connected to a conductive pattern 170 enables the conductive pattern 170 to play a role in compensating for the voltage drop of the signal line 131. That is, arranging the conductive pattern 170 to be electrically connected to the signal line 131 is able to reduce the resistance value of a signal transmission path (i.e., the whole formed by the signal line 131 and the conductive pattern 170 after being electrically connected together), and reduce the voltage drop of the signal transmission path (i.e., the whole formed by the signal line 131 and the conductive pattern 170 after being electrically connected together), thereby reducing the voltage drop of the signal line 131. In this way, it is possible to reduce the loss of the signal in the transmission process, improve the reliability of the transmission of the signal, and improve the luminous efficiency of the electronic component 120.

It can be understood that since the voltage drop of the signal line 131 can be reduced after the conductive pattern 170 is electrically connected to the signal line 131, even if the width of the signal line 131 along the first direction X is set to be small, or the thickness of the signal line 131 is set to be small, the voltage drop of the signal line 131 is made to still be able to satisfy the demands through the compensating effect of the conductive pattern 170.

That is to say, by arranging the conductive pattern 170 to be electrically connected to the signal line 131, in an aspect, it is advantageous to reduce the width of the signal line 131 along the first direction X, thereby reducing the space occupied by the signal line 131 on the base 101, and improving the ease of the wiring of the substrate 100; and in another aspect, it is also advantageous to reduce the thickness of the signal line 131, thereby reducing the amount of the material of the signal line 131, and lowering the cost of the substrate 100.

In addition, as shown in FIG. 3C, in a case where a signal line 131 (e.g., the fifth signal line 131e) located in the side edge region AA21 is electrically connected to a conductive pattern 170, the width of the signal line 131 along the first direction X decreases, which is also possible to reduce the space occupied by the signal line 131 in the side edge region AA21, thereby facilitating a reduction in the width of the side edge region AA21, and facilitating the realization of a narrow frame (side frame) of the substrate 100.

Moreover, in a case where the signal line 131 (e.g., the fifth signal line 131e) located in the side edge region AA21 is electrically connected to the conductive pattern 170, it is also possible to reduce the voltage drop of the signal line 131 in the side edge region AA21, improving the electrical performance of the signal line 131 located in the side edge region AA21.

**It** can be understood that the base 101 has a fixed area, so the narrower the frame of the substrate 100 is, the greater the number of the device groups 110 capable of being arranged; and in a case where the electronic components 120 included in the device groups 110 are light-emitting components, the large overall brightness of the substrate 100 is able to improve the performance of the substrate 100.

Moreover, since the conductive pattern 170 is able to avoid the device group 110, the signal line group 130, etc., the setting of the conductive pattern 170 does not affect the function of the substrate 100, thereby improving the reliability of the substrate 100.

As can be seen from the above, the multiple electronic components 120 in the device group 110 are electrically connected together through the connecting lines 112. **In** some examples, as shown in FIG. 3C, multiple connection lines 112 in a device group 110 arranged at intervals. An electronic component 120 includes two pins, where one pin is soldered to an end of a connection line 112 and the other pin is soldered to an end of another connection line 112. **In** this way, as shown in FIG. 2F, it enables the electronic component 120 to be located in a region Q after being soldered to the connection lines 112 (refer to FIG. 3A and FIG. 3B for the positional relationship of the electronic components 120 after being soldered to the connection lines 112).

**It** can be understood that except for a region where the connection line 112 is connected to the pin, which is exposed by the insulating layer, the other regions of the connection line 112 are covered by the insulating layer.

**In** some embodiments, the plurality of conductive patterns 170 are disposed in the same layer as the plurality of signal line groups 130.

It can be understood that "same layer" refers to using a single film formation process to form an entire layer structure, and then using a patterning process to form specific patterns in different regions. Depending on different specific patterns, the single patterning process may include at least one exposure, development or etching process. The specific patterns may be continuous or discontinuous, and these specific patterns may also be at different heights or have different thicknesses.

In some examples, the plurality of conductive patterns 170 and the plurality of signal line groups 130 may be of the same material and in the same layer, thereby simplifying the process of manufacturing the substrate 100 and lowering the manufacturing cost.

The method of manufacturing the substrate 100 is described below by way of example.

In some examples, the base 101 is made of glass. For example, a magnetron sputtering process may be used to form a buffer layer on a side of the base 101. For example, the material of the buffer layer may include at least one of tungsten, titanium, nickel, aluminum, a nickel alloy, and a titanium-tungsten alloy.

A conductive layer is formed on a side of the buffer layer away from the base 101. For example, the material of the conductive layer includes copper. In some examples, a magnetron sputtering process may be used to form the conductive layer on the side of the buffer layer away from the base 101. In some other examples, an electroplating process may be used to form the conductive layer on the side of the buffer layer away from the base 101. In still some other examples, a magnetron sputtering process and an electroplating process may be used to form the conductive layer on the side of the buffer layer away from the base 101.

The conductive layer is patterned to form the plurality of signal line groups 130 and the plurality of conductive patterns 170 by processes, such as cleaning, coating, baking, photo, development, hard baking, etching, and stripping.

An insulating layer is formed on a side of the patterned conductive layer away from the base 101, and the insulating layer is able to cover the conductive layer to serve as an electrical isolation. For example, the insulating layer may be formed using a magnetron sputtering process, or the insulating layer may be formed using chemical vapor deposition (CVD) or physical vapor deposition (PVD).

It can be understood that the plurality of conductive patterns 170 are disposed in the same layer as the plurality of signal line groups 130, in an aspect, it is possible to simplify the process steps when patterning the conductive layer, reduce the number of masks, and lower the BOM (Bill of Material) cost, thereby lowering the cost of manufacturing the substrate 100.

In another aspect, the plurality of conductive patterns 170 are disposed in the same layer as the plurality of signal line groups 130, which can increase an area of orthographic projections of conductive structures (e.g., the signal line groups 130 and the conductive patterns 170) on the base 101.

For example, without providing the conductive pattern 170, the area of the orthographic projections of the conductive structures in the conductive layer (the plurality of signal line groups 130) on the base 101 is about 20% of the area of the base 101. After providing the conductive pattern 170, the area of the orthographic projections of the conductive structures in the conductive layer (the plurality of signal line groups 130 and the plurality of conductive patterns 170) on the base 101 is about 75% of the area of the base 101.

Considering an example in which the conductive layer is made of copper (Cu), the plurality of conductive patterns 170 are disposed in the same layer as the plurality of signal line groups 130, which is able to increase a ratio of the area of Cu in the conductive layer to the area of the base 101 from about 20% to about 75%, so as to increase the area of Cu in the conductive layer, thereby decreasing the amount of etching solution used in the etching process and lowering the cost of the substrate 100.

In some embodiments, as shown in FIG. 3A and FIG. 3B, the substrate 100 further includes a plurality of bridging parts 140. The plurality of bridging parts 140 are located on the same side of the base 101 as the plurality of device groups 110, and at least one bridging part 140 is located in the device region AA.

It can be understood that the bridging part 140 acts as a conductor of electricity. In some examples, the bridging part 140 is made of a conductive material, such as made of copper or aluminum. In some other examples, the bridging part 140 may be an electrical element, such as a resistor or capacitor. It can be understood that the plurality of bridging parts 140 may be the same or may be different.

It can be understood that the plurality of bridging parts 140 are located on the same side of the base 101 as the plurality of device groups 110, that is, the plurality of bridging parts 140, the plurality of device groups 110, the plurality of conductive patterns 170, and the plurality of signal line groups 130 are all located on the same side of the base 101.

It can be understood that at least one bridging part 140 is located in the device region AA, which enables at least one bridging part 140 to be electrically connected to a conductive pattern 170, and/or, at least one bridging part 140 to be electrically connected to a signal line 131.

As can be seen from the above, the plurality of conductive patterns 170 are disposed in the same layer as the plurality of signal line groups 130. In some examples, the plurality of bridging parts 140 are located on a side, away from the base 101, of both the plurality of conductive patterns 170 and the plurality of signal line groups 130, so as to prevent the bridging parts 140 from affecting the signal lines 131 and the conductive patterns 170.

In some examples, a side of the plurality of bridging parts 140 away from the base 101 is provided with a protective layer. The protective layer is able to cover the plurality of bridging parts 140 to provide electrical isolation, and is also able to play a role in protecting the plurality of bridging parts 140.

In some embodiments, as shown in FIG. 3A and FIG. 3B, the plurality of signal line groups 130 includes a first voltage line group 150, and the first voltage line group 150 includes multiple first voltage lines 151.

In some examples, the first voltage lines 151 are used for supplying power to the electronic components 120 in the device groups 110. For example, as shown in FIG. 3A and FIG. 3B, one end of a first voltage line 151 is electrically connected to a bonding pin in the bonding region BB, and the other end extends to the device region AA and is electrically connected to a column of device groups 110 arranged along the second direction Y. That is, these device groups 110 in the column arranged along the second direction Y share this first voltage line 151.

In some examples, as shown in FIG. 3A and FIG. 3B, a first voltage line 151 in the first voltage line group 150 may be disposed in the side edge region AA21, so as to enable the first voltage line 151 to be electrically connected to a column of device groups 110 adjacent to the side edge region AA21 along the first direction X.

In some examples, as shown in FIG. 3D, the substrate 100 further includes a circuit board 107, and the circuit board 107 is electrically connected to the bonding region BB.

For example, as shown in FIG. 3D, the circuit board 107 includes a flexible circuit board (i.e., a flexible printed circuit, FPC for short) 105 and a printed circuit board (PCB) 106. One end of the flexible circuit board 105 is bonded to the bonding pins in the bonding region BB, and the other end is bonded to the printed circuit board 106, to enable signals to be transmitted between the plurality of signal line groups 130 and the printed circuit board 106, thereby realizing driving of the plurality of device groups 110.

In some examples, a power supply external to the substrate 100 is electrically connected to the first voltage lines 151 through the printed circuit board 106 and the bonding pins, enabling the power supply to power electronic components 120 in a column of device groups 110 through a first voltage line 151, thereby enabling the electronic components 120 to emit light.

In some examples, as shown in FIG. 3A and FIG. 3B, the plurality of signal line groups 130 further includes a second voltage line group 160, and the second voltage line group 160 includes multiple second voltage lines 161.

In some examples, the second voltage lines (Ground, GND for short) 161 are used to ground the first driving chips 103. For example, as shown in FIG. 3A and FIG. 3B, one end of a second voltage line 161 is electrically connected to a bonding pin in the bonding region BB, and the other end extends to the device region AA and is electrically connected to a first driving chip 103. As can be seen from the above, the first driving chip 103 is electrically connected to the device group 110, so that the second voltage line 161 is able to be electrically connected to the device group 110 through the first driving chip 103.

In some examples, as shown in FIG. 3A and FIG. 3B, a second voltage line 161 in the second voltage line group 160 may be disposed in the side edge region AA21, so as to enable the second voltage line 161 to be electrically connected to a column of device groups 110 adjacent to the side edge region AA21 along the first direction X.

In some examples, as shown in FIG. 3E, a first driving chip 103 includes a first output port CH1, a second output port CH2, a third output port CH3, and a fourth output port CH4. The first output port CH1, the second output port CH2, the third output port CH3, and the fourth output port CH4 are electrically connected to four device groups 110, respectively, so that the first driving chip 103 is able to be electrically connected to the four device groups 110.

In some examples, as shown in FIG. 3D and FIG. 3E, the substrate 100 further includes a second driving chip 104. For example, the second driving chip 104 may be disposed on the printed circuit board 106.

In some examples, the second driving chip 104 is a Tx IC (transmit integrated circuit), and the first driving chip 103 is an Rx IC (receive integrated circuit). Signals sent from the second driving chip 104 are transmitted to the first driving chips 103 through the bonding pins and the signal line groups 130 (e.g., the second voltage line groups 160), thereby realizing the driving of the device groups 110.

In some examples, as shown in FIG. 3E, the second driving chip 104 has a first ground port GNDa and a second ground port GNDb, and the first driving chip 103 similarly has a first ground port GND1 and a second ground port GND2. The second voltage lines 161 include 1^{st} second voltage line 161a and 2^{nd} second voltage line 161b.

As shown in FIG. 3E, one end of the 1^{st} second voltage line 161a is electrically connected to the first ground port GNDa of the second driving chip 104 through a bonding pin of the bonding region BB, and the other end of the 1^{st} second voltage line 161a is electrically connected to the first ground port GND1 of the first driving chip 103; and one end of the 2^{nd} second voltage line 161b is electrically connected to the second ground port GNDb of the second driving chip 104 through a bonding pin of the bonding region BB, and the other end of the 2^{nd} second voltage line 161b is electrically connected to the second ground port GND2 of the first driving chip 103.

It will be noted that the 1^{st} second voltage line 161a and the 2^{nd} second voltage line 161b are only used to differentiate between the two second voltage lines 161, without further limiting the second voltage lines 161.

In some other examples, the first driving chip 103 may include only one ground port. In this case, one end of a second voltage line 161 is electrically connected to a ground port of the second driving chip 104 through a bonding pin of the bonding region BB, and the other end is electrically connected to the ground port of the first driving chip 103 to ground the first driving chip 103.

**In** some examples, as shown in FIG. 3E, in a case where a column of device groups 110 arranged along the second direction Y is electrically connected to multiple first driving chips 103, the multiple first driving chips 103 electrically connected to the same column of device groups 110 may share a second voltage line 161.

As shown in FIG. 3A and FIG. 3B, the plurality of conductive patterns 170 include multiple first conductive patterns 171, and the multiple first conductive patterns 171 are each electrically connected to at least one first voltage line 151 in the first voltage line group 150.

**In** some examples, one first voltage line 151 in the first voltage line group 150 is electrically connected to a first conductive pattern 171. **In** some other examples, multiple first voltage lines 151 in the first voltage line group 150 are each electrically connected to a first conductive pattern 171.

**In** some examples, as shown in FIG. 3A and FIG. 3B, at least two first voltage lines 151 are electrically connected to the same first conductive pattern 171.

As can be seen from the above, the first voltage lines 151 are used to supply constant-voltage high-level signal for the electronic components 120 in the device groups 110. Therefore, the width of the first voltage line 151 along the first direction X is usually large. **In** this way, arranging the first conductive pattern 171 electrically connected to at least one first voltage line 151 in the first voltage line group 150 is able to, in an aspect, improve the transmission reliability of the electrical signal supplied, thereby improving the luminous efficiency of the electronic components 120. **In** another aspect, it is advantageous to reduce the width of the first voltage line 151 along the first direction X, thereby improving the ease of the wiring of the substrate 100. **In** yet another aspect, it is also advantageous to reduce the thickness of the first voltage line 151, thereby reducing the amount of the material used for the first voltage line 151 and lowering the cost of the substrate 100.

As shown in FIG. 3A and FIG. 3B, one first voltage line 151 in the first voltage line group 150 may be located in the side edge region AA21. For example, the first conductive pattern 171 may be electrically connected to the first voltage line 151 located in the side edge region AA21 to reduce a width of the first voltage line 151 located in the side edge region AA21 along the first direction X, thereby facilitating a reduction in the side edge region AA21 along the first direction X, and thereby facilitating the realization of a narrow frame (side frame) of the substrate 100.

In some embodiments, the width of the first voltage line 151 along the first direction X takes a value in a range of 0.5 mm to 1 mm.

It can be understood that in a case where no conductive pattern 170 is provided, the width of the first voltage line 151 along the first direction X takes a value in a range of 2 mm to 15 mm, to satisfy the voltage drop demand.

By contrast, in the embodiments of the present disclosure, the first conductive pattern 171 is arranged to be electrically connected to the first voltage line 151, so that the first conductive pattern 171 is able to compensate for the voltage drop of the first voltage line 151, which is conducive to reducing the width of the first voltage line 151 along the first direction X. In this way, the range of the value of the width of the first voltage line 151 along the first direction X can be reduced to 0.5 mm to 1 mm, thereby facilitating the realization of the narrow frame of the substrate 100.

It can be understood that setting the width of the first voltage line 151 along the first direction X to take a value in the range of 0.5 mm to 1 mm, avoids the width of the first voltage line 151 along the first direction X from being too large (e.g., greater than 1 mm), thereby facilitating the realization of the narrow frame of the substrate 100. In addition, the width of the first voltage line 151 along the first direction X is also avoided from being too small (e.g., less than 0.5 mm), thereby improving the transmission reliability of the constant-voltage high-level signals.

In some examples, the width of the first voltage line 151 along the first direction X may take a value in a range of 0.6 mm to 0.9 mm or 0.7 mm to 0.8 mm. For example, the width of the first voltage line 151 along the first direction X may take the value of 0.6 mm, 0.7 mm, 0.8 mm, or 0.9 mm.

It can be understood that the widths of the first voltage lines 151 along the first direction X may be the same or different.

In some embodiments, as shown in FIG. 3A and FIG. 3B, the plurality of conductive patterns 170 include multiple second conductive patterns 172, and the multiple second conductive patterns 172 are each electrically connected to at least one second voltage line 161 in the second voltage line group 160.

In some examples, one second voltage line 161 in the second voltage line group 160 is electrically connected to a second conductive pattern 172. In some other examples, multiple second voltage lines 161 in the second voltage line group 160 are each electrically connected to a second conductive pattern 172.

**In** some examples, as shown in FIG. 3A and FIG. 3B, at least two second voltage lines 161 are electrically connected to the same second conductive pattern 172.

As can be seen from the above, the second voltage lines 161 are used to ground the first driving chips 103. Therefore, the width of the second voltage line 161 along the first direction X is usually large. **In** this way, arranging the first conductive pattern 171 electrically connected to at least one second voltage line 161 in the second voltage line group 160 can, in an aspect, improve the transmission reliability of the electrical signal supplied. **In** another aspect, it is advantageous to reduce the width of the second voltage line 161 along the first direction X, thereby improving the ease of the wiring of the substrate 100. **In** yet another aspect, it is also advantageous to reduce the thickness of the second voltage line 161, thereby reducing the amount of the material used for the second voltage line 161 and lowering the cost of the substrate 100.

As shown in FIG. 3A and FIG. 3B, one second voltage line 161 in the second voltage line group 160 may be located in the side edge region AA21. For example, the second conductive pattern 172 may be electrically connected to the second voltage line 161 located in the side edge region AA21 to reduce a width of the second voltage line 161 located in the side edge region AA21 along the first direction X, thereby facilitating a reduction in the side edge region AA21 along the first direction X, and thereby facilitating the realization of a narrow frame (side frame) of the substrate 100.

**In** some embodiments, the width of the second voltage line 161 along the first direction X takes a value in a range of 0.5 mm to 1 mm.

**It** can be understood that in a case where no conductive pattern 170 is provided, the width of the second voltage line 161 along the first direction X takes a value in a range of 2 mm to 15 mm, to satisfy the voltage drop demand.

By contrast, in the embodiments of the present disclosure, the second conductive pattern 172 is arranged to be electrically connected to the second voltage line 161, so that the second conductive pattern 172 is able to compensate for the voltage drop of the second voltage line 161, which is conducive to reducing the width of the second voltage line 161 along the first direction X. **In** this way, the range of the value of the width of the second voltage line 161 along the first direction X can be reduced to 0.5 mm to 1 mm, thereby facilitating the realization of the narrow frame of the substrate 100.

It can be understood that setting the width of the second voltage line 161 along the first direction X to take a value in the range of 0.5 mm to 1 mm, avoids the width of the second voltage line 161 along the first direction X from being too large (e.g., greater than 1 mm), thereby facilitating the realization of the narrow frame of the substrate 100. In addition, the width of the second voltage line 161 along the first direction X is also avoided from being too small (e.g., less than 0.5 mm), thereby improving the transmission reliability of the electrical signals.

In some examples, the width of the second voltage line 161 along the first direction X may take a value in a range of 0.6 mm to 0.9 mm or 0.7 mm to 0.8 mm. For example, the width of the second voltage line 161 along the first direction X may take the value of 0.6 mm, 0.7 mm, 0.8 mm, or 0.9 mm.

It can be understood that the widths of the plurality of second voltage lines 161 along the first direction X may be the same or different; and the width of the first voltage line 151 along the first direction X may be the same as, or may be different from, the width of the second voltage line 161 along the first direction X.

In some embodiments, as shown in FIG. 3A and FIG. 3B, a first voltage line 151, which is electrically connected to a column of device groups 110, and a second voltage line 161, which is electrically connected to this column of device groups 110, are arranged at intervals along the first direction X.

In some examples, as shown in FIG. 3A and FIG. 3B, a first voltage line 151 is located, along the first direction X, on a side of the central region AA1; and a second voltage line 161 is located, along the first direction X, on a side of the central region AA1 away from the first voltage line 151.

In some examples, as shown in FIG. 3A and FIG. 3B, any first voltage line 151 is located, along the first direction X, on a first side of a column of device groups 110 electrically connected to this first voltage line 151. It can be understood that the first side may be either of both sides of the column of device groups 110 along the first direction X.

In some examples, as shown in FIG. 3A and FIG. 3B, a first voltage line 151 and a first driving chip 103, which are electrically connected to the same column of device groups 110, are located on opposite sides of the column of device groups 110 along the first direction X. For example, a first end of the device group 110 is electrically connected to the first driving chip 103, a second end is electrically connected to the first voltage line 151, and the first end and the second end are disposed opposite to each other along the first direction X, such that the first voltage line 151 and the first driving chip 103, which are electrically connected to the same column of device groups 110, are able to be located at opposite sides of the column of device groups 110 along the first direction X.

In some examples, as shown in FIG. 3A and FIG. 3B, any second voltage line 161 is located, along the first direction X, on a second side of a column of device groups 110 electrically connected to this second voltage line 161. It can be understood that the second side may be either of both sides of the column of device groups 110 along the first direction X.

It can be seen from the above that any first voltage line 151 is located, along the first direction X, on a first side of a column of device groups 110 electrically connected to this first voltage line 151. In some examples, the first side and the second side are opposite sides of the column of device groups 110 along the first direction X. That is, as shown in FIG. 3A and FIG. 3B, the first voltage line 151 and the second voltage line 161, which are electrically connected to the column of device groups 110, are located on both sides of the column of device groups 110 along the first direction X. With this arrangement, the mutual influence between the first voltage line 151 and the second voltage line 161 is reduced.

In some examples, as shown in FIG. 3A and FIG. 3B, the second voltage line 161 and the first driving chip 103, which are electrically connected to the same column of device groups 110, are located on the same side of this column of device groups 110 along the first direction X.

As can be seen from the above, the substrate 100 includes the plurality of bridging parts 140. In some embodiments, as shown in FIG. 3A and FIG. 3B, the substrate 100 further includes multiple first bridging parts 141, and at least one first conductive pattern 171 is electrically connected to a first voltage line 151 through a first bridging part 141.

For example, as shown in FIG. 3A and FIG. 3B, one end of a first bridging part 141 is electrically connected to a first conductive pattern 171, and the other end is electrically connected to a first voltage line 151, so that at least one first conductive pattern 171 is able to be electrically connected to the first voltage line 151 through the first bridging part 141.

As can be seen from the above, the insulating layer is able to cover the conductive layer (that is, the insulating layer is able to cover the plurality of signal line groups 130 and the plurality of conductive patterns 170), so as to provide electrical isolation. **In** some examples, after forming the insulating layer, first through holes may be formed in the insulating layer, and the first bridging part 141 is electrically connected to both the first conductive pattern 171 and the first voltage line 151 through first through holes.

**It** can be understood that by providing the first bridging part 141, even if other conductive structures (e.g., other signal lines 131) are provided between the first conductive pattern 171 and the first voltage line 151, the first bridging part 141 is still able to electrically connect the two, which improves the flexibility of the wiring of the substrate 100 and meets different usage requirements.

Furthermore, the current-carrying capacity of the first bridging part 141 may be adjusted by adjusting the width, thickness, etc., of the first bridging part 141. **In** some examples, the width and thickness of the first bridging part 141 may be increased, enabling the first bridging part 141 to have a large current-carrying capacity. **In** some other examples, the width and thickness of the first bridging part 141 may be reduced, enabling the first bridging part 141 with a small current-carrying capacity. **In** this way, different usage requirements are met and the applicability of the substrate 100 is improved.

**In** some embodiments, as shown in FIG. 3A and FIG. 3B, at least one first conductive pattern 171 and a first voltage line 151 form a one-piece structure.

**It** can be understood that the first conductive pattern 171 and the first voltage line 151 form the one-piece structure, which means that the first conductive pattern 171 is electrically connected to the first voltage line 151 directly, and no other conductive structure (e.g., the first bridging part 141) is provided therebetween.

Arranging at least one first conductive pattern 171 to form the one-piece structure with the first voltage line 151 is able to improve the reliability of the electrical connection between the first conductive pattern 171 and the first voltage line 151, and there is no need to provide other conductive structures, which simplifies the structure of the substrate 100 and lowers the cost of the substrate 100.

**It** can be understood that in a case where multiple first conductive patterns 171 are electrically connected to first voltage lines 151, a part (one or more) of the first conductive patterns 171 may be electrically connected to first voltage line(s) 151 through first bridging part(s) 141, and the other part (one or more) of the first conductive patterns 171 may form a one-piece structure with first voltage line(s) 151.

**In** some embodiments, as shown in FIG. 3A and FIG. 3B, the substrate 100 further includes multiple second bridging parts 142, and at least one second conductive pattern 172 is electrically connected to a second voltage line 161 through a second bridging part 142.

For example, as shown in FIG. 3A and FIG. 3B, one end of a second bridging part 142 is electrically connected to a second conductive pattern 172, and the other end is electrically connected to a second voltage line 161, so that at least one second conductive pattern 172 is able to be electrically connected to the second voltage line 161 through the second bridging part 142.

As can be seen from the above, the insulating layer is able to cover the conductive layer (that is, the insulating layer is able to cover the plurality of signal line groups 130 and the plurality of conductive patterns 170), so as to provide electrical isolation. **In** some examples, after forming the insulating layer, second through holes may be formed in the insulating layer, and the second bridging part 142 is electrically connected to both the second conductive pattern 172 and the second voltage line 161 through first through holes.

**It** can be understood that by providing the second bridging part 142, even if other conductive structures (e.g., other signal lines 131) are provided between the second conductive pattern 172 and the second voltage line 161, the second bridging part 142 is still able to electrically connect the two, which improves the flexibility of the wiring of the substrate 100 and meets different usage requirements.

Furthermore, the current-carrying capacity of the second bridging part 142 may be adjusted by adjusting the width, thickness, etc., of the second bridging part 142. **In** some examples, the width and thickness of the second bridging part 142 may be increased, enabling the second bridging part 142 to have a large current-carrying capacity. **In** some other examples, the width and thickness of the second bridging part 142 may be reduced, enabling the second bridging part 142 with a small current-carrying capacity. **In** this way, different usage requirements are met and the applicability of the substrate 100 is improved.

As can be seen from the above, two adjacent electronic components 120 are electrically connected through a connection line 112. In some examples, the connection lines 112 are also disposed in the conductive layer, that is, the connection lines 112 are disposed in the same layer as the plurality of signal line groups 130 and the plurality of conductive patterns 170 (including the first conductive patterns 171 and the second conductive patterns 172). The insulating layer is also provided therein with third through holes, and a third through hole exposes a partial region of a connection line 112, and the exposed region of a surface of the connection line 112 serves as a pad, enabling a pin of an electronic component 120 to be electrically connected to the pad. In this way, multiple electronic components 120 in a device group 110 may be connected in series through connection lines 112.

The following is an example of a method of forming through holes (including the first through holes, the second through holes, and the third through holes) in the insulating layer.

In some examples, a photoresist layer may be formed on a side of the insulating layer away from the conductive layer by processes such as coating, photo, and development. The photoresist layer is patterned by an etching process to expose the insulating layer at positions where the through holes need to be formed. The exposed portion of the insulating layer is removed by the etching process to form the through holes (including the first through holes, the second through holes, and the third through holes).

In some examples, the electronic components 120 may be soldered to the pads after the insulating layer is patterned, and then the bridging parts 140 (including the first bridging parts 141 and the second bridging parts 142) are electrically connected to the signal lines 131 (including the first voltage lines 151 and the second voltage lines 161) and the conductive patterns 170 (including the first conductive patterns 171 and the second conductive patterns 172).

In some embodiments, as shown in FIG. 3F, at least one second conductive pattern 172 and a second voltage line 161 form a one-piece structure.

It can be understood that the second conductive pattern 172 and the second voltage line 161 form the one-piece structure, which means that the second conductive pattern 172 is electrically connected to the second voltage line 161 directly, and no other conductive structure (e.g., the first bridging part 141) is provided therebetween.

Arranging at least one second conductive pattern 172 to form the one-piece structure with the second voltage line 161 is able to improve the reliability of the electrical connection between the second conductive pattern 172 and the second voltage line 161, and there is no need to provide other conductive structures, which simplifies the structure of the substrate 100 and lowers the cost of the substrate 100.

**It** can be understood that in a case where multiple second conductive patterns 172 are electrically connected to a second voltage line 161, a part (one or more) of the second conductive patterns 172 may be electrically connected to the second voltage line 161 through first bridging part(s) 141, and the other part (one or more) of the second conductive patterns 172 may form a one-piece structure with the second voltage line 161.

**In** some embodiments, at least one of the plurality of bridging parts 140 is a jumper resistor.

**It** can be understood that the jumper resistor is a special-purpose resistor, and the resistance value of the jumper resistor is very small but not exactly zero. **In** some examples, an automated mounter or an automated plug-in machine may be employed to place the jumper resistor between two points in the substrate 100 that cannot be directly connected through a line to electrically connect the two points.

**In** some examples, the plurality of bridging parts 140 may all be jumper resistors; while in some other examples, some (one or more) of the plurality of bridging parts 140 may be jumper resistors.

**It** can be understood that setting at least one of the plurality of bridging parts 140 to be a jumper resistor is able to improve the ease of processing of the substrate 100 and lower the cost of the substrate 100. Moreover, since the resistance value of the jumper resistor is small, the voltage drop is small, improving the reliability of the signal transmission.

**In** some embodiments, at least one of the plurality of first bridging parts 141 is a jumper resistor.

Such a setting is able to improve the ease of processing of the substrate 100 and lower the cost of the substrate 100. Moreover, since the resistance value of the jumper resistor is small, the voltage drop is small, improving the reliability of the signal transmission.

**In** some examples, the multiple first bridging parts 141 may all be jumper resistors; while in some other examples, some (one or more) of the multiple first bridging parts 141 may be jumper resistors.

**In** some embodiments, at least one of the plurality of second bridging parts 142 is a jumper resistor.

Such a setting is able to improve the ease of processing of the substrate 100 and lower the cost of the substrate 100. Moreover, since the resistance value of the jumper resistor is small, the voltage drop is small, improving the reliability of the signal transmission.

**In** some examples, the multiple second bridging parts 142 may all be jumper resistors; while in some other examples, some (one or more) of the multiple second bridging parts 142 may be jumper resistors.

As can be seen from the above, the plurality of signal line groups 130 include the first voltage line group 150 and the second voltage line group 160. With reference to FIG. 3D and FIG. 3E below, other signal line groups 130 in the plurality of signal line groups 130 are illustrated by way of example.

**In** some examples, as shown in FIG. 3D and FIG. 3E, the plurality of signal line groups 130 further include a power line group 135, and the power line group 135 includes multiple power lines 132.

**In** some examples, a power line (volt current condenser, VCC for short) 132 is used to supply power first driving chips 103. For example, as shown in FIG. 3D and FIG. 3E, one end of the power line 132 is electrically connected to a bonding pin in the bonding region **BB,** and the other end extends to the device region AA and is electrically connected to the first driving chips 103. As can be seen from the above, the first driving chip 103 is electrically connected to the device group 110, enabling the power line 132 to be electrically connected to the device group 110 through the first driving chip 103.

**In** some examples, as shown in FIG. 3E, the first driving chip 103 has a power port Vcc. One end of the power line 132 is electrically connected to a power supply external to the substrate 100 through the bonding pin and the printed circuit board 106, and the other end is electrically connected to the power port Vcc of the first driving chip 103, enabling the power line 132 to realize the power supply for the first driving chip 103.

**In** some examples, as shown in FIG. 3D and FIG. 3E, any power line 132 is located, along the first direction X, on a second side of a column of device groups 110 electrically connected to the power line 132. That is, the power line 132 and the second voltage line 161, which are electrically connected to the same column of device groups 110, are located along the first direction X on the same side of the column of device groups 110.

In some examples, as shown in FIG. 3D and FIG. 3E, the plurality of signal line groups 130 further include a data line group 136, and the data line group 136 includes multiple data lines 133.

In some examples, the data line 133 is used to transmit a data signal. For example, as shown in FIG. 3D and FIG. 3E, one end of the data line 133 is electrically connected to a bonding pin in the bonding region BB, and the other end extends to the device region AA and is electrically connected to first driving chips 103. As can be seen from the above, the first driving chip 103 is electrically connected to the device group 110, enabling the data line 133 to be electrically connected to the device group 110 through the first driving chip 103.

In some examples, as shown in FIG. 3D and FIG. 3E, a first driving chip 103 has a data port Dip, and a second driving chip 104 has a first data port Dip1 to an N^{th} data port DipN. One end of a data line 133 is electrically connected, through a bonding pin and the printed circuit board 106, to the first data port Dip1 of the second driving chip 104, and the other end is electrically connected to data port(s) Dip of first driving chip(s) 103 electrically connected to a column of device groups 110. One end of another data line 133 is electrically connected, through a bonding pin and the printed circuit board 106, to the second data port Dip2 of the second driving chip 104, and the other end is electrically connected to data port(s) Dip of first driving chip(s) 103 electrically connected to another column of device groups 110, and so forth until the N^{th} data port DipN. It can be understood that N is a positive integer. In some examples, N takes the same value as the number of columns along the second direction Y in which the device groups 110 are arranged.

In some examples, as shown in FIG. 3D and FIG. 3E, any data line 133 is located, along the first direction X, on a second side of a column of device groups 110 electrically connected to the data line 133. That is, a data line 133 and a second voltage line 161, which are electrically connected to the same column of device groups 110, are located on the same side of the column of device groups 110 along the first direction X.

In some examples, as shown in FIG. 3D and FIG. 3E, there are multiple first driving chips 103 electrically connected to a column of device groups 110. For example, the multiple first driving chips 103 electrically connected to the column of device groups 110 include a 1^{st} first driving chip 103a, a 2^{nd} first driving chip 103b, a 3^{rd} first driving chip 103c, a 4^{th} first driving chip 103d, and all the way up to an m^{th} first driving chip 103m. It can be understood that the multiple first driving chips 103 are provided in a cascade.

For example, as shown in FIG. 3E, the 1^{st} first driving chip 103a to the m^{th} first driving chip 103m are sequentially away from the bonding region BB along the second direction Y. It can be understood that m is greater than 4, and m is a positive integer.

It will be noted that the 1^{st} first driving chip 103a, the 2^{nd} first driving chip 103b, the 3^{rd} first driving chip 103c, the 4^{th} first driving chip 103d, and all the way up to the m^{th} first driving chip 103m are only used to differentiate the multiple first driving chips 103 electrically connected to a column of device groups 110, without further limiting the first driving chips 103.

In some examples, as shown in FIG. 3D and FIG. 3E, the plurality of signal line groups 130 further include an input/output line group 137, and the input/output line group 137 includes input/output lines (also called addressing signal lines) 134. For example, as shown in FIG. 3D and FIG. 3E, the input/output lines 134 include input line(s) 1341 and output line(s) 1342.

In some examples, as shown in FIG. 3E, the second driving chip 104 has input ports DiN and output ports DoN; and the first driving chip 103 has an input port Dis and an output port Dos.

For example, as shown in FIG. 3E, there are multiple input lines 1341, in which one end of one input line 1341 is electrically connected to the input port DiN of the second driving chip 104 through a bonding pin, and the other end is electrically connected to the input port Dis of the 1^{st} first driving chip 103a; one end of another input line 1341 is electrically connected to the output port Dos of the 1^{st} first driving chip 103a, and the other end is electrically connected to the input port Dis of the 2^{nd} first driving chip 103b; one end of yet another input line 1341 is electrically connected to the output port Dos of the 2^{nd} first driving chip 103b, and the other end is electrically connected to the input port Dis of the 3^{rd} first driving chip 103c; and so on up to the m^{th} first driving chip 103m which is furthest away from the bonding region BB along the second direction Y.

For example, as shown in FIG. 3E, the output port Dos of the m^{th} first driving chip 103m is electrically connected to a bonding pin in the bonding region BB through an output line 1342. That is, the multiple first driving chips 103 electrically connected to a column of device groups 110 are realized in a cascade arrangement by means of the input lines 1341 and the output line 1342.

In this way, signals output by the second driving chip 104 can be transmitted to multiple first driving chips 103 through the input lines 1341, and then fed back to the second driving chip 104 through the output line 1342, enabling the second driving chip 104 to realize the driving of the multiple first driving chips 103.

In some examples, as shown in FIG. 3D and FIG. 3E, any input/output line 134 is located, along the first direction X, on a second side of a column of device groups 110 electrically connected to the input/output line 134. That is, the input/output line 134 and the second voltage line 161, which are electrically connected to the same column of device groups 110, are located on the same side of the column of device groups 110.

In some examples, as shown in FIG. 3D and FIG. 3E, the input/output lines 134 surround the second voltage lines 161 to conserve wiring space and improve area utilization of the substrate 101.

In some examples, as shown in FIG. 3D and FIG. 3E, the first voltage line 151, the power line 132, the data line 133, the input line 1341, the second voltage line 161, and the output line 1342 are arranged in sequence along a direction from a column of device groups 110 to first driving chip(s) 103 electrically connected to the column of device groups 110.

In some examples, as shown in FIG. 3D and FIG. 3E, the substrate 100 further includes an electrostatic loop 108. The electrostatic loop 108 is disposed around the plurality of device groups 110 and is electrically coupled to the bonding region BB.

For example, both ends of the electrostatic loop 108 are electrically connected to the bonding pins in the bonding region BB, so that the electrostatic loop 108 is able to surround not only the plurality of device groups 110, but also the plurality of signal line groups 130 electrically connected to the plurality of device groups 110.

It can be understood that the electrostatic loop 108 is able to play the role of releasing static electricity, thereby protecting the plurality of device groups 110 and the plurality of signal line groups 130 and improving the reliability of the substrate 100.

**It** can be understood that an arrangement order of the bonding pins in the bonding region **BB** along the first direction X is the same as an arrangement order of the electrostatic loop 108, the first voltage line 151, the power line 132, the data line 133, the input line 1341, the second voltage line 161, the output line 1342, etc., along the first direction.

Such an arrangement is able to shorten a distance between the bonding pins and both the signal lines 131 and the electrostatic loop 108, thereby shortening the length of the lines (including the signal lines 131 and the electrostatic loop 108), reducing the voltage drop of the lines (including the signal lines 131 and the electrostatic loop 108), and improving the reliability of the substrate 100. **It** is also possible to lower the amount of the material and lower the cost.

As can be seen from the above, the arrangement of electrically connecting at least one signal line 131 in the at least one signal line group 130 to a conductive pattern 170 is able to reduce the voltage drop of the signal line 131.

Referring to Table 1 below, the voltage drops of the first voltage line 151, the second voltage line 161, and the power line 132 with and without providing the conductive pattern 170 are illustrated.

**TABLE 1**

| | | Resistance value (unit: ohms Ω) | | | Voltage drop (unit: voltage V) |
|---|---|---|---|---|---|
| | | Lower edge region (refer to region AA22 in FIG. 2G) | Central region and side edge region (refer to regions AA1 and AA21 in FIG. 2G) | Total | |
| Without the conductive pattern: the first voltage line, the second voltage line, and the power line are made of the same material (e.g., Cu), and each signal line has the thickness of 4.5 µm | First voltage line | 1.0485 | 0.4786 | 1.5271 | 0.2632 |
| | Second voltage line | 1.8937 | 0.8168 | 2.7105 | 0.3122 |
| | Power line | 10.2655 | 3.2196 | 13.4851 | 0.1439 |
| Sum of the voltage drop of the second voltage line and the voltage drop of the power line | 0.4561 | | | | |
| With the conductive pattern: the first voltage line, the second voltage line, and the power line are made of the same material (e.g., Cu), and each signal line has the thickness of 3.6 µm | First voltage line | 1.3513 | 0.6168 | 1.9681 | 0.3392 |
| | Second voltage line | 0.9498 | 0.3691 | 1.3189 | 0.2218 |
| | Power line | 9.8171 | 2.1888 | 12.0059 | 0.1234 |
| Sum of the voltage drop of the second voltage line and the voltage drop of the power line | 0.3452 | | | | |

As shown in Table 1, simulation tests are performed on the first voltage line group 150, the second voltage line group 160, and the power line group 135 taking an example in which the material of the conductive layer is Cu.

Table 1 shows the resistance values and voltage drops of the longest first voltage line 151 in the first voltage line group 150, the longest second voltage line 161 in the second voltage line group 160, and the longest power line 132 in the power line group 135. For example, in two cases of not providing the conductive pattern 170 and providing the conductive pattern 170, the length of the first voltage line 151 is the same, the length of the second voltage line 161 is the same, and the length of the power line 132 is the same; and in the two cases of not providing the conductive pattern 170 and providing the conductive pattern 170, the width of the first voltage line 151 along the first direction X is about 4 mm, the width of the second voltage line 161 along the first direction X is about 3.3 mm, and the width of the power line 132 along the first direction X is about 0.34 mm. That is, in the two cases of not providing the conductive pattern 170 and providing the conductive pattern 170, the width of the first voltage line 151 along the first direction X is the same, the width of the second voltage line 161 along the first direction X is the same, and the width of the power line 132 along the first direction X is the same. On this basis, by controlling the three to have different thicknesses, different resistance values and voltage drops are obtained.

As shown in Table 1, without providing the conductive pattern 170, each of the first voltage line 151, the second voltage line 161, and the power line 132 has a large resistance, resulting in a large voltage drop. For example, the voltage drop of the first voltage line 151 reaches 0.2632 V, the voltage drop of the second voltage line 161 reaches 0.3122 V, and the voltage drop of the power line 132 reaches 0.1439 V, where the sum of the voltage drop of the second voltage line 161 and the voltage drop of the power line 132 reaches 0.4561 V.

Under normal circumstances, the voltage drop of the first voltage line 151 needs to be less than 0.5 V, the voltage drop of the second voltage line 161 needs to be less than 0.4 V, and the sum of the voltage drop of the second voltage line 161 and the voltage drop of the power line 132 needs to be less than 0.45 V. It can be understood that since the second voltage line 161 is used to ground the first driving chip 103, and the power line 132 is used to supply power to the first driving chip 103, if the voltage drop of the second voltage line 161 and the voltage drop of the power line 132 are too large (e.g., the sum of which greater than 0.45 V), it will cause the power consumption of the first driving chip 103 to increase, causing the temperature of the first driving chip 103 to increase and affecting the reliability of the first driving chip 103.

As can be seen from Table 1, without providing the conductive pattern 170, even if the thickness of Cu is large (e.g., 4.5 µm), the sum of the voltage drop of the second voltage line 161 and the voltage drop of the power line 132 is 0.4561 V, which is still unable to meet the demand and reduces the reliability of the first driving chip 103.

By contrast, in the embodiments of the present disclosure, the conductive patterns 170 are provided to be electrically connected to the signal lines 131 (e.g., the first voltage lines 151 and the second voltage lines 161), enabling the conductive patterns 170 to compensate for the voltage drop of the signal lines 131.

For example, as shown in Table 1, the first conductive pattern 171 is electrically connected to the first voltage line 151, and the second conductive pattern 172 is electrically connected to the second voltage line 161, therefore, the voltage drop of the first voltage line 151 is able to drop to 0.3392 V, the voltage drop of the second voltage line 161 is able to drop to 0.2218 V, and the sum of the voltage drop of the second voltage line 161 and the voltage drop of the power line 132 is able to drop to 0.3452 V. That is, by arranging the conductive pattern 170, even if Cu has a small thickness (e.g., 3.6 µm), the voltage drop is still able to meet the demand, which reduces the amount of Cu and lowers the cost of the substrate 100.

As can be seen from the above, the input/output lines 134 include the input line 1341 and the output line 1342. In some examples, as shown in FIG. 3D, the input/output lines 134 include first input/output lines 134a, and the first input/output lines 134a are located in the side edge region AA21 and electrically connected to a column of device groups 110 adjacent to the side edge region AA2 along the first direction X. For example, the first input/output lines 134a include a first input line 1341a and a first output line 1342a.

In some examples, as shown in FIG. 3D, the first output line 1342a extends to the central region AA1 through the side edge region AA21 and is electrically connected to other output lines 1342. In this way, the first output line 1342a does not need to occupy the space of the side edge region AA21, which facilitates the reduction of the width of the side edge region AA21, and thus facilitates the realization of the narrow frame (side frame) of the substrate 100.

In some examples, the first output line 1342a extends to the central region AA1 and is electrically connected to an output line 1342 adjacent to the first output line 1342a along the first direction X.

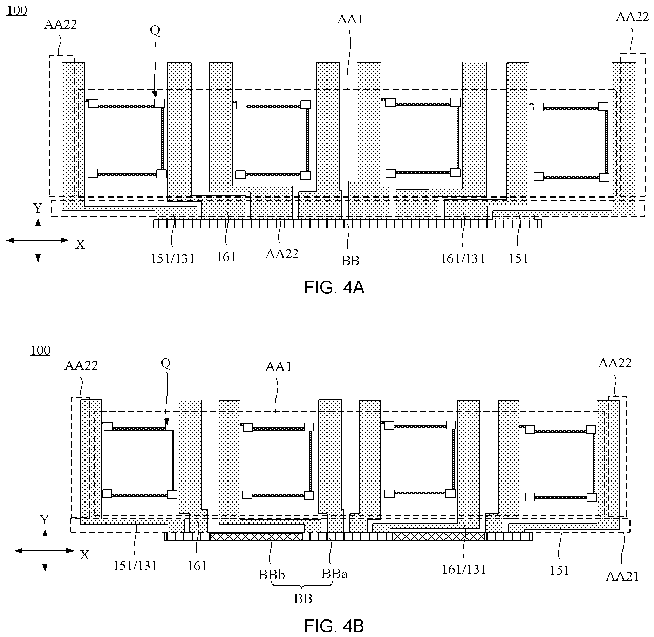

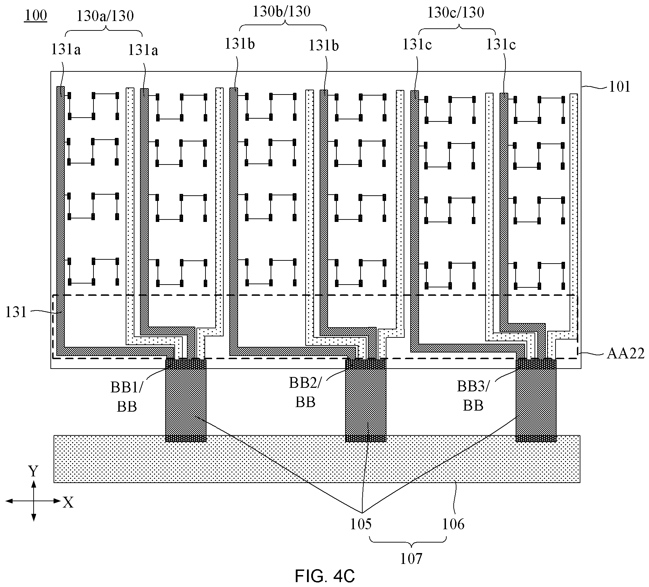

FIG. 4A is a structural diagram of a substrate in accordance with still yet some other embodiments. FIG. 4B is a structural diagram of a substrate in accordance with still yet some other embodiments. FIG. 4C is a structural diagram of a substrate in accordance with still yet some other embodiments.

As can be seen from the above, arranging the conductive patterns 170 (including the first conductive patterns 171 and the second conductive patterns 172) to be electrically connected to the signal lines 131 (e.g., the first voltage lines 151 and the second voltage lines 161) is able to reduce the width of the signal line 131 along the first direction X, thereby facilitating a reduction in the width of the side edge region AA21 of the substrate 100, and facilitating the realization of the narrow frame of the substrate 100. The substrate 100 will continue to be illustrated with reference to FIG. 4A to FIG. 4C.

In some implementations, as shown in FIG. 4A, the signal lines 131 (e.g., the first voltage lines 151 and the second voltage lines 161) in the device region AA need to extend along the first direction X and the second direction Y in the lower edge region AA22 to be able to be electrically connected to the bonding pins in the bonding region BB. It can be understood that the signal lines 131 extend along the first direction X in the lower edge region AA22, increasing the space occupied by the signal lines 131 in the lower edge region AA22. Moreover, in a case where the number of the signal lines 131 is large, it will lead to increased difficulty in wiring within the lower edge region AA22, which is not conducive to realizing the narrow frame (lower frame) of the substrate 100.

In some implementations, as shown in FIG. 4B, the bonding region BB includes a pin region BBa and a floating bonding region BBb. It can be understood that the pin region BBa is provided therein with the bonding pins, and the floating bonding region BBb is provided therein with dummy pins. By arranging the dummy pins, it is possible to regulate the setting position (pin map) of the bonding pins, shorten a distance between a signal line 131 and a bonding pin electrically connected to the signal line 131, thereby shortening a length of a portion, extending along the first direction X in the lower edge region AA22, of the signal line 131.

In the related art, bonding regions BB are provided therein with a plurality of bonding pins arranged at equal spacing along the first direction X, and each signal line group 130 is electrically connected to some of bonding pins in a bonding region BB. The bonding regions BB include a first bonding region BB1, a second bonding region BB2, and a third bonding region BB3, in which the first bonding region BB1, the second bonding region BB2, and the third bonding region BB3 are each connected to a different signal line group 130; and the first bonding region BB1, the second bonding region BB2, and the third bonding region BB3 are arranged sequentially along the first direction X. The inventors of the present disclosure have found that, as shown in FIG. 4C, the first bonding region BB1 is electrically connected to a first signal line group 130a, and if a center axis along the second direction Y of the first signal line group 130a is far from a center axis along the second direction Y of the first bonding region BB1 in the first direction X, the signal line 131 needs to extend a distance along the first direction X in the lower edge region AA22 to be connected to the first bonding region BB1, which is not conducive to realizing the narrow frame of the substrate 100; and if a center axis along the second direction Y of a signal line group 130 (e.g., the first signal line group 130a) electrically connected to a certain bonding region BB (e.g., the first bonding region BB1) is disposed, in the first direction X, as close as possible to a center axis along the second direction Y of the bonding region BB (e.g., the first bonding region BB1), the floating bonding region BBb that is not connected to any signal line needs to be provided between different bonding pins in the bonding region BB. In a case where there are a large number of signal lines 131, there are also a large number of bonding pins, thus there is not sufficient space to arrange a large number of floating bonding regions BBb, resulting in the signal lines 131 still needing to extend along the first direction X in the lower edge region AA22 for a long distance, which is not conducive to the realization of the narrow frame of the substrate 100.

It can be seen that the way of arranging the floating bonding region BBb is less applicable and does not effectively alleviate the problem of the wide width of the lower frame of the substrate 100.

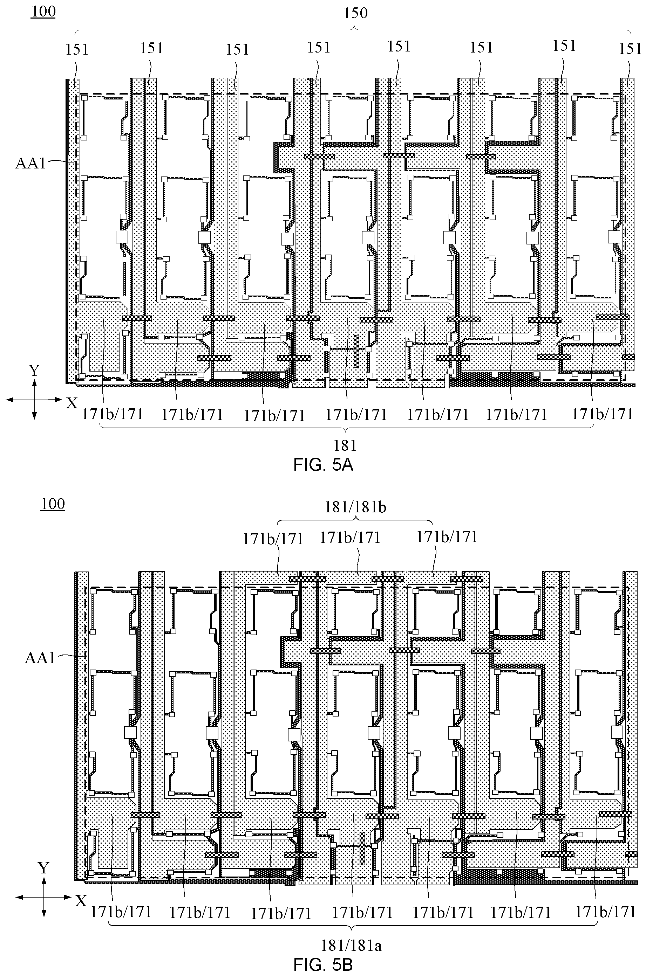

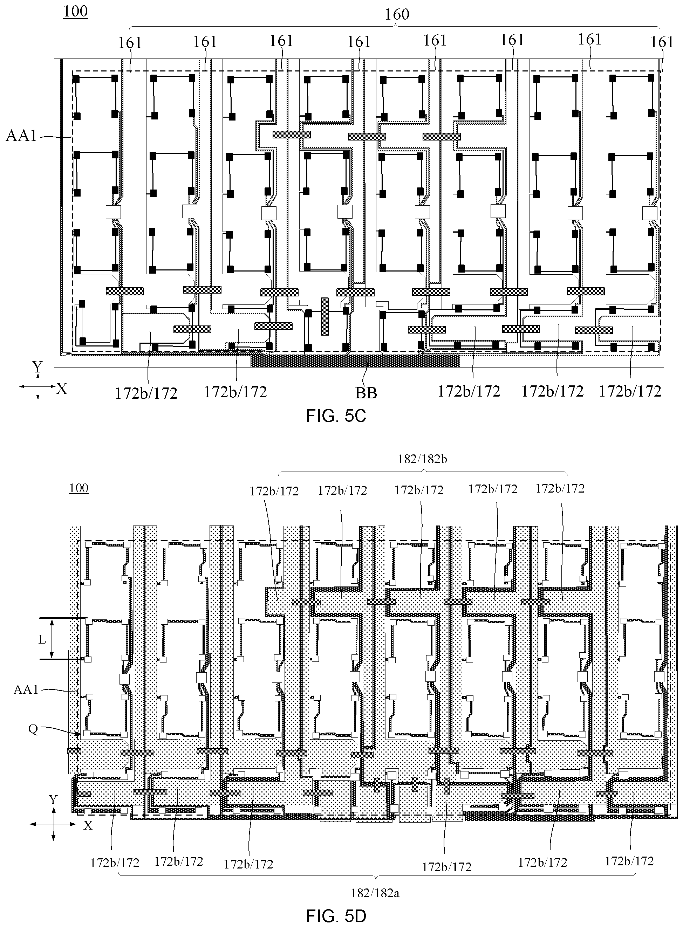

FIG. 5A is a structural diagram of a substrate in accordance with still yet some other embodiments. FIG. 5B is a structural diagram of a substrate in accordance with still yet some other embodiments. FIG. 5C is a structural diagram of a substrate in accordance with still yet some other embodiments. FIG. 5D is a structural diagram of a substrate in accordance with still yet some other embodiments.

In some embodiments, as shown in FIG. 5A and FIG. 5B, at least two first conductive patterns 171 are arranged along the first direction X.

It can be understood that at least two first voltage lines 151 in a first voltage line group 150 may be electrically connected to the same first conductive pattern 171. Therefore, the at least two first conductive patterns 171 are arranged along the first direction X, enabling multiple first voltage lines 151 to be electrically connected by the at least two first conductive patterns 171 arranged along the first direction X.

It can be understood that arranging multiple first voltage lines 151 electrically connected by at least two first conductive patterns 171 arranged along the first direction X is able to reduce the voltage drop of the first voltage lines 151, facilitate reducing the thickness of the first voltage lines 151, and lower the cost of the substrate 100. Moreover, multiple first voltage lines 151 are electrically connected by the at least two first conductive patterns 171, such that electrically connecting any one of the multiple first voltage lines 151 electrically connected to the bonding region BB can enable signals to be transmitted between the bonding pins and the multiple first voltage lines 151 electrically connected to each other, so as to improve the ease of the wiring of the substrate 100.

In some examples, as shown in FIG. 5A and FIG. 5B, the first conductive patterns 171 include second-type first conductive patterns 171b, and the second-type first conductive patterns 171b are located in the central region AA1. Multiple first voltage lines 151 are electrically connected to the second-type first conductive patterns 171b arranged along the first direction X.

It can be understood that the second-type first conductive patterns 171b are located in the central region AA1, enabling the multiple first voltage lines 151 to be electrically connected in sequence in the central region AA1. That is, the multiple first voltage lines 151 do not need to be electrically connected to the bonding region BB in the lower edge region AA22 individually, but can be electrically connected to each other in the central region AA1 through the second-type first conductive patterns 171b, and then through one or more (less than the number of the first voltage lines 151) electrical structures (e.g., conductive patterns 170 or bridging parts 140) are electrically connected together to the bonding pins in the bonding region BB.

In this way, the multiple first voltage lines 151 do not need to extend along the first direction X in the lower edge region AA22, which is beneficial to reducing the width of the lower edge region AA22 and realizing the narrow frame (lower frame) of the substrate 100. Moreover, there is no need to adjust the position of the bonding pins connected to the first voltage line group 150, which simplifies the process of manufacturing the substrate 100. In addition, by arranging the second-type first conductive patterns 171b to electrically connect the multiple first voltage lines 151, the narrow frame of the substrate 100 is realized, which has high applicability and can meet different wiring requirements.

In some examples, the multiple first voltage lines 151 are electrically connected, and they are further electrically connected to at least one bonding pin through a conductive structure (e.g., first conductive patterns 171 or first bridging parts 141). It can be understood that a center axis along the second direction Y of a region where the at least one bonding pin connected to the first voltage line group 150 to which the multiple first voltage lines 151 belong, substantially coincides with a center axis along the second direction Y of the conductive structure.

In some embodiments, as shown in FIG. 5C and FIG. 5D, at least two second conductive patterns 172 are arranged along the first direction X.

It can be understood that at least two second voltage lines 161 in a second voltage line group 160 may be electrically connected to the same second conductive pattern 172. Therefore, the at least two second conductive patterns 172 are arranged along the first direction X, enabling multiple second voltage lines 161 to be electrically connected by the at least two second conductive patterns 172 arranged along the first direction X.

It can be understood that arranging multiple second voltage lines 161 electrically connected by at least two second conductive patterns 172 arranged along the first direction X is able to reduce the voltage drop of the second voltage lines 161, facilitate reducing the thickness of the second voltage lines 161, and lower the cost of the substrate 100. Moreover, multiple second voltage lines 161 are electrically connected by the at least two second conductive patterns 172, such that electrically connecting any one of the multiple second voltage lines 161 electrically connected to the bonding region BB can enable signals to be transmitted between the bonding pins and the multiple second voltage lines 161 electrically connected to each other, so as to improve the ease of the wiring of the substrate 100.

In some examples, as shown in FIG. 5C and FIG. 5D, the second conductive patterns 172 include second-type second conductive patterns 172b, and the second-type second conductive patterns 172b are located in the central region AA1. Multiple second voltage lines 161 are electrically connected to the second-type second conductive patterns 172b arranged along the first direction X.

It can be understood that the second-type second conductive patterns 172b are located in the central region AA1, enabling the multiple second voltage lines 161 to be electrically connected in sequence in the central region AA1. That is, the multiple second voltage lines 161 do not need to be electrically connected to the bonding region BB in the lower edge region AA22 individually, but can be electrically connected to each other in the central region AA1 through the second-type second conductive patterns 172b, and then through one or more (less than the number of the first voltage lines 151) electrical structures (e.g., conductive patterns 170 or bridging parts 140) are electrically connected together to the bonding pins in the bonding region BB.

In this way, the multiple second voltage lines 161 do not need to extend along the first direction X in the lower edge region AA22, which is beneficial to reducing the width of the lower edge region AA22 and realizing the narrow frame (lower frame) of the substrate 100. Moreover, there is no need to adjust the position of the bonding pins connected to the second voltage line group 160, which simplifies the process of manufacturing the substrate 100. In addition, by arranging the second-type second conductive patterns 172b to electrically connect the multiple second voltage lines 161, the narrow frame of the substrate 100 is realized, which has high applicability and can meet different wiring requirements.

In some examples, the multiple second voltage lines 161 are electrically connected, and they are further electrically connected to at least one bonding pin through a conductive structure (e.g., second conductive patterns 172 or second bridging parts 142). It can be understood that a center axis along the second direction Y of a region where the at least one bonding pin connected to the second voltage line group 160 to which the multiple second voltage lines 161 belong, substantially coincides with a center axis along the second direction Y of the conductive structure.

In some embodiments, as shown in FIG. 5B, at least two first conductive patterns 171 arranged along the first direction X form a first conductive pattern row 181, and multiple first conductive patterns 171 form at least two first conductive pattern rows 181.

It can be understood that the at least two first conductive pattern rows 181 may have the same or a different number of first conductive patterns 171.

In some examples, at least two first conductive pattern rows 181 are electrically connected to multiple first voltage lines 151 in the first voltage line group 150. In some other examples, a part (two or more) of the first voltage lines 151 in the first voltage line group 150 are electrically connected together through one first conductive pattern row 181, and another part (two or more) of the first voltage lines 151 are electrically connected together through another first conductive pattern row 181.

In some examples, at least two first conductive pattern rows 181 are arranged at intervals along the second direction Y. In some other examples, at least two first conductive pattern rows 181 are arranged at intervals along the first direction X.

It can be understood that multiple first conductive patterns 171 are provided to form at least two first conductive pattern rows 181, enabling multiple first voltage lines 151 to be electrically connected together through at least two first conductive pattern rows 181, which improves the wiring flexibility of the substrate 100.

In some embodiments, as shown in FIG. 5B, there are two first conductive pattern rows 181, and the numbers of first conductive patterns 171 included in the two first conductive pattern rows 181 are different.

It can be understood that first conductive patterns 171 belonging to the same first conductive pattern row 181 may have different shapes and different sizes, which are not limited herein. A part (one or more) of the first conductive patterns 171 belonging to the same first conductive pattern row 181 are in direct contact with and form a one-piece structure with a first voltage line 151 adjacent thereto, and another part (one or more) of the first conductive patterns 171 are arranged at intervals from the first voltage line 151 and are connected through the first bridging part 141.

With such an arrangement, it is possible to set different first conductive pattern rows 181 to include different numbers of first conductive patterns 171 depending on the usage requirements, which improves the wiring flexibility of the substrate 100.

In some embodiments, as shown in FIG. 5B, the length of any device group 110 along the second direction Y is L. Along the second direction Y, one first conductive pattern row 181 (e.g., a first conductive pattern row 181a in FIG. 5B) is closer to the bonding region BB relative to another first conductive pattern row 181 (e.g., a first conductive pattern row 181b in FIG. 5B); and along the second direction Y, a spacing between the two first conductive pattern rows 181 (the first conductive pattern row 181a and the first conductive pattern row 181b) takes a value in a range of 3L to 5L.

It can be understood that the first conductive pattern row 181a and the first conductive pattern row 181b are only used to differentiate between the two first conductive pattern rows 181 arranged at intervals along the second direction Y, without further limiting the first conductive pattern rows 181. Since the length of any device group 110 along the second direction Y is L, that is, the first conductive pattern row 181a is spaced apart from the first conductive pattern row 181b by 3 to 5 rows of device groups 110.

With such an arrangement, the spacing between the first conductive pattern row 181a and the first conductive pattern row 181b along the second direction Y may be avoided from being too small (e.g., less than 3L), which means that the first conductive patterns 171 may be avoided to be arranged too densely, resulting in an excessive current in a partial region of the substrate 100, causing a localized overheating of the substrate 100. Moreover, it is also avoided that the spacing between the first conductive pattern row 181a and the first conductive pattern row 181b along the second direction Y is too large (e.g., greater than 5L), which means that the compensation effect of the first conductive patterns 171 for the voltage drop of the first voltage lines 151 may be avoided to be affected.

That is, setting the spacing between the first conductive pattern row 181a and the first conductive pattern row 181b in the range of 3L to 5L is able to improve the uniformity of the heat of the substrate 100 at different locations, avoid the substrate 100 from being locally overheated, thereby improving the reliability of the substrate 100. Moreover, it can also improve the compensation effect of the first conductive pattern 171 for the voltage drop of the first voltage line 151 and reduce the voltage drop of the first voltage line 151. In some examples, the spacing between the first conductive pattern row 181a and the first conductive pattern row 181b may be 3L, 4L, or 5L.

In some embodiments, as shown in FIG. 5D, at least two second conductive patterns 172 arranged along the first direction X form a second conductive pattern row 182, and multiple second conductive patterns 172 form at least two second conductive pattern rows 182.

It can be understood that the at least two second conductive pattern rows 182 may have the same or a different number of second conductive patterns 172.

In some examples, at least two second conductive pattern rows 182 are electrically connected to multiple second voltage lines 161 in the second voltage line group 160. In some other examples, a part (two or more) of the second voltage lines 161 in the second voltage line group 160 are electrically connected together through one second conductive pattern row 182, and another part (two or more) of the second voltage lines 161 are electrically connected together through another second conductive pattern row 182.

In some examples, at least two second conductive pattern rows 182 are arranged at intervals along the second direction Y. In some other examples, at least two second conductive pattern rows 182 are arranged at intervals along the first direction X.

It can be understood that multiple second conductive patterns 172 are provided to form at least two second conductive pattern rows 182, enabling multiple second voltage lines 161 to be electrically connected together through at least two second conductive pattern rows 182, which improves the wiring flexibility of the substrate 100.

In some embodiments, as shown in FIG. 5D, there are two second conductive pattern rows 182, and the numbers of second conductive patterns 172 included in the two second conductive pattern rows 182 are different.

It can be understood that second conductive patterns 172 belonging to the same second conductive pattern row 182 may have different shapes and different sizes, which are not limited herein. A part (one or more) of the second conductive patterns 172 belonging to the same second conductive pattern row 182 are in direct contact with and form a one-piece structure with a second voltage line 161 adjacent thereto, and another part (one or more) of the second conductive patterns 172 are arranged at intervals from the second voltage line 161 and are connected through the second bridging part 142.

With such an arrangement, it is possible to set different second conductive pattern rows 182 to include different numbers of second conductive patterns 172 depending on the usage requirements, which improves the wiring flexibility of the substrate 100.

In some embodiments, as shown in FIG. 5D, the length of any device group 110 along the second direction Y is L. Along the second direction Y, one second conductive pattern row 182 (e.g., a second conductive pattern row 182a in FIG. 5D) is closer to the bonding region BB relative to another second conductive pattern row 182 (e.g., a second conductive pattern row 182b in FIG. 5D); and along the second direction Y, a spacing between the two second conductive pattern rows 182 (the second conductive pattern row 182a and the second conductive pattern row 182b) takes a value in a range of 3L to 5L.

It can be understood that the second conductive pattern row 182a and the second conductive pattern row 182b are only used to differentiate between the two second conductive pattern rows 182 arranged at intervals along the second direction Y, without further limiting the second conductive pattern rows 182. Since the length of any device group 110 along the second direction Y is L, that is, the second conductive pattern row 182a is spaced apart from the second conductive pattern row 182b by 3 to 5 rows of device groups 110.

With such an arrangement, the spacing between the second conductive pattern row 182a and the second conductive pattern row 182b along the second direction Y may be avoided from being too small (e.g., less than 3L), which means that the second conductive patterns 172 may be avoided to be arranged too densely, resulting in an excessive current in a partial region of the substrate 100, causing a localized overheating of the substrate 100. Moreover, it is also avoided that the spacing between the second conductive pattern row 182a and the second conductive pattern row 182b along the second direction Y is too large (e.g., greater than 5L), which means that the compensation effect of the second conductive patterns 172 for the voltage drop of the second voltage lines 161 may be avoided to be affected.

That is, setting the spacing between the second conductive pattern row 182a and the second conductive pattern row 182b in the range of 3L to 5L is able to improve the uniformity of the heat of the substrate 100 at different locations, and avoid the substrate 100 from being locally overheated, thereby improving the reliability of the substrate 100. Moreover, it can also improve the compensation effect of the second conductive pattern 172 for the voltage drop of the second voltage line 161 and reduce the voltage drop of the second voltage line 161.

In some examples, the spacing between the second conductive pattern row 182a and the second conductive pattern row 182b may be 3L, 4L, or 5L.

It can be understood that the spacing between the second conductive pattern row 182a and the second conductive pattern row 182b may be the same as, or may be different from the spacing between the first conductive pattern row 181a and the first conductive pattern row 181b.

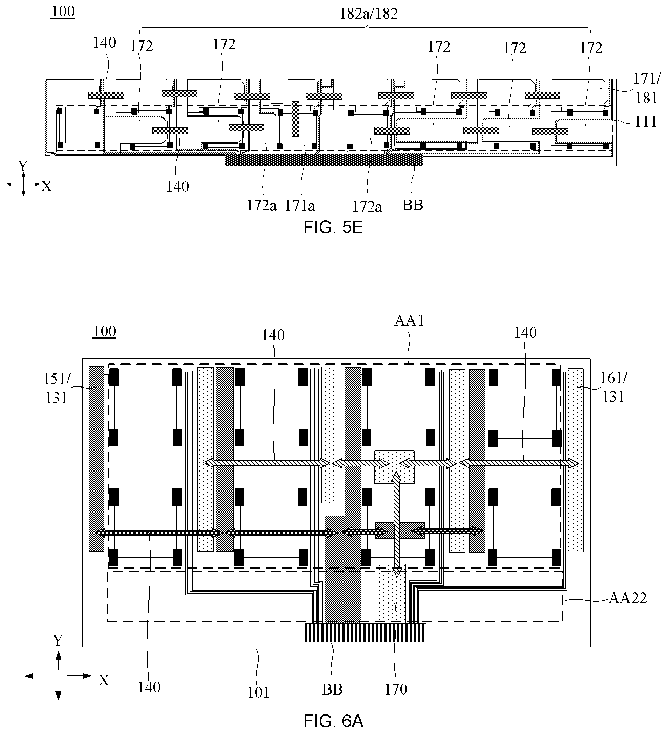

FIG. 5E is a structural diagram of a substrate in accordance with still yet some other embodiments.

In some embodiments, as shown in FIG. 5E, the plurality of device groups 110 include a first row of device groups 111 adjacent to the bonding region BB along the second direction Y. It can be understood that the first row of device groups 111 is the row of device groups 110 closest to the bonding region BB along the second direction Y in all rows of device groups 110.

In some examples, at least one first conductive pattern row 181 is located in a region where the first row of device groups 111 is located. That is, first conductive patterns 171 in the at least one first conductive pattern row 181 are located in a region where device groups 110 in the first row of device groups 111 are located.

Such an arrangement is able to shorten a distance between the first conductive pattern row 181 and the bonding region BB, and improve the convenience of the electrical connection between the first conductive patterns 171 in the first conductive pattern row 181 and the bonding region BB.

As can be seen from the above, the first conductive pattern row 181a is closer to the bonding region BB relative to the first conductive pattern row 181b. That is, the first conductive pattern row 181a may be located in the region where the first row of device groups 111 is located.

In some embodiments, as shown in FIG. 5E, at least one second conductive pattern row 182 is located in a region where the first row of device groups 111 is located.

The at least one second conductive pattern row 181 is located in the region where the first row of device groups 111 is located, which means that second conductive patterns 172 in the at least one second conductive pattern row 182 are located in a region where device groups 110 in the first row of device groups 111 are located.

Such an arrangement is able to shorten a distance between the second conductive pattern row 182 and the bonding region BB, and improve the convenience of the electrical connection between the second conductive patterns 172 in the second conductive pattern row 182 and the bonding region BB.

As can be seen from the above, the second conductive pattern row 182a is closer to the bonding region BB relative to the second conductive pattern row 182b. That is, the second conductive pattern row 182a may be located in the region where the first row of device groups 111 is located.

In some examples, as shown in FIG. 5E, in a case where the second conductive pattern row 182 is located in the region where the first row of device groups 111 is located, the first conductive pattern row 181 is located, along the second direction Y, on a side of the second conductive pattern row 182 away from the bonding region BB.

As can be seen from the above, in some examples, the signal lines 131 (including the first voltage lines 151 or the second voltage lines 161) are electrically connected in the central region AA1, and then are electrically connected together to the bonding pins in the bonding region BB.

The following is an example of a manner in which the signal lines 131, after being electrically connected, are electrically connected together to the bonding pins in the bonding region BB.

Referring again to FIG. 5C and FIG. 5D, in some embodiments, at least one signal line 131 in at least one signal line group 130 is electrically connected to the bonding region BB through a conductive pattern 170.

In some examples, as shown in FIG. 5C and FIG. 5D, at least two signal lines 131 (e.g., first voltage lines 151) in a signal line group 130 (e.g., a first voltage line group 150) are electrically connected, and then electrically connected to a bonding pin in the bonding region BB through a conductive pattern 170.

It can be understood that arranging the at least two signal lines 131 to be electrically connected is able to reduce the voltage drop of the signal lines 131, which is conducive to reducing the thickness of the signal lines 131. Moreover, after the at least two signal lines 131 are electrically connected, they are then electrically connected to the bonding pin in the bonding region BB through the conductive pattern 170, which improves the convenience of the electrical connection between the at least two signal lines 131 and the bonding pin.

In some other examples, one signal line 131 in one signal line group 130 is electrically connected to a bonding pin in the bonding region BB through a conductive pattern 170 to meet different usage requirements, thereby improving the flexibility of the substrate 100.

It can be understood that arranging at least one signal line 131 in at least one signal line group 130 to be electrically connected to the bonding region BB is able to improve the reliability of the electrical connection between the signal line 131 and the bonding pin, and reduce the voltage drop, thereby improving the reliability of the substrate 100.

In some embodiments, as shown in FIG. 5E, the multiple first conductive patterns 171 include first-type first conductive pattern(s) 171a. One end of a first-type first conductive pattern 171a is directly connected to an end of the bonding region BB proximate to the device region AA, and the other end of the first-type first conductive pattern 171a is electrically connected to a first voltage line group 150.

It can be understood that the first-type first conductive pattern 171a is able to extend from the bonding region BB to the device region AA. One end of the first-type first conductive pattern 171a is directly connected to an end of the bonding region BB proximate to the device region AA. That is, one end of the first-type first conductive pattern 171a is electrically connected to an end of the bonding region BB proximate to the device region AA directly, and no other conductive structure is provided between the two. It can be understood that the first-type first conductive pattern 171a may be electrically connected to multiple bonding pins in the bonding region BB.

The other end of the first-type first conductive pattern 171a is electrically connected to the first voltage line group 150. That is, the other end of the first-type first conductive pattern 171a is electrically connected to multiple first voltage lines 151 in the first voltage line group 150.

As can be seen from the above, in some examples, as shown in FIG. 5B, multiple first voltage lines 151 in the first voltage line group 150 are electrically connected together through the second-type first conductive patterns 171b. For example, one end of the first-type first conductive pattern 171a away from the bonding region BB is electrically connected to the second-type first conductive pattern 171b, enabling the first-type first conductive pattern 171a to electrically connect the multiple first voltage lines 151 to the bonding pin.

It can be understood that since the conductive patterns 170 (including the first-type first conductive pattern 171a) have a strong current-carrying capacity, the first voltage line group 150 is arranged to be electrically connected to the bonding pin in the bonding region BB through the first-type first conductive pattern 171a, which improves the reliability of the electrical connection between the first voltage line group 150 and the bonding pin.

In some embodiments, the number of the first-type first conductive pattern(s) 171a is a, where a is less than the number of the first voltage lines 151 in the first voltage line group 150, and a is a positive integer.

It can be understood that the number a of the first-type first conductive pattern(s) 171a is set to be less than the number of the first voltage lines 151, that is, multiple first voltage lines 151 are capable of electrically connecting to the bonding region BB through the first-type first conductive pattern(s) 171a, the number of which is less than the number of the first voltage lines 151, after electrically connecting to the second-type first conductive patterns 171b located in the device region AA. In this way, in an aspect, it is possible to reduce the number of bonding pins electrically connected to the first voltage lines 151, thereby reducing the width of the flexible circuit board 105 along the first direction X to lower the cost; and in another aspect, it is possible to simplify the structure of the substrate 100 and improve the ease of the wiring of the substrate 100.

In some examples, a may take a value of 2. That is, the multiple first voltage lines 151 in the first voltage line group 150 are electrically connected to bonding pins in the bonding region BB through two first-type first conductive patterns 171a.

In some other examples, a may take a value of 1. That is, the multiple first voltage lines 151 in the first voltage line group 150 are electrically connected to bonding pins in the bonding region BB through one first-type first conductive pattern 171a.

In some embodiments, a is not greater than half of the number of the first voltage lines 151 in the first voltage line group 150.

It can be understood that a is not greater than half the number of the first voltage lines 151 in the first voltage line group 150, that is, a is less than or equal to half the number of the first voltage lines 151. Such an arrangement is able to reduce the number of the first-type first conductive pattern(s) 171a, thereby reducing the number of bonding pins electrically connected to the first voltage lines 151, and reducing the width of the flexible circuit board 105 along the first direction X, so as to lower the cost of the substrate 100.

In some examples, in a case where the value of a is small (e.g., the value of a is 1 or 2), the width of the first-type first conductive pattern 171a along the first direction X may be increased to enable the first-type first conductive pattern 171a to be bonded and connected to a larger number of bonding pins, so as to reduce the value of the current on the first-type first conductive pattern 171a, reduce the heat dissipation of the first-type first conductive pattern 171a, and improve the reliability of the substrate 100.

In some embodiments, as shown in FIG. 5E, the multiple second conductive patterns 172 include first-type second conductive pattern(s) 172a. One end of a first-type second conductive pattern 172a is directly connected to an end of the bonding region BB proximate to the device region AA, and the other end of the first-type second conductive pattern 172a is electrically connected to a second voltage line group 160.

It can be understood that the first-type second conductive pattern 172a is able to extend from the bonding region BB to the device region AA. One end of the first-type second conductive pattern 172a is directly connected to an end of the bonding region BB proximate to the device region AA. That is, one end of the first-type second conductive pattern 172a is electrically connected to an end of the bonding region BB proximate to the device region AA directly, and no other conductive structure is provided between the two. It can be understood that the first-type second conductive pattern 172a may be electrically connected to multiple bonding pins in the bonding region BB.

The other end of the first-type second conductive pattern 172a is electrically connected to the second voltage line group 160. That is, the other end of the first-type second conductive pattern 172a is electrically connected to multiple second voltage lines 161 in the second voltage line group 160.

As can be seen from the above, in some examples, as shown in FIG. 5D, multiple second voltage lines 161 in the second voltage line group 160 are electrically connected together through the second-type second conductive patterns 172b. For example, one end of the first-type second conductive pattern 172a away from the bonding region BB is electrically connected to the second-type second conductive pattern 172b, enabling the first-type second conductive pattern 172a to electrically connect the multiple second voltage lines 161 to the bonding pin.

It can be understood that since the conductive patterns 170 (including the first-type second conductive pattern 172a) have a strong current-carrying capacity, the second voltage line group 160 is arranged to be electrically connected to the bonding pin in the bonding region BB through the first-type second conductive pattern 172a, which improves the reliability of the electrical connection between the second voltage line group 160 and the bonding pin.

In some embodiments, the number of the first-type second conductive pattern(s) 172a is b, where b is less than the number of the second voltage lines 161 in the second voltage line group 160, and b is a positive integer.

It can be understood that the number b of the first-type second conductive pattern(s) 172a is set to be less than the number of the second voltage lines 161, that is, multiple second voltage lines 161 are capable of electrically connecting to the bonding region BB through the first-type second conductive pattern(s) 172a, the number of which is less than the number of the second voltage lines 161, after electrically connecting to the second-type second conductive patterns 172b located in the device region AA. In this way, in an aspect, it is possible to reduce the number of bonding pins electrically connected to the second voltage lines 161, thereby reducing the width of the flexible circuit board 105 along the first direction X to lower the cost; and in another aspect, it is possible to simplify the structure of the substrate 100 and improve the wiring convenience of the substrate 100.

In some examples, b may take a value of 2. That is, the multiple second voltage lines 161 in the second voltage line group 160 are electrically connected to bonding pins in the bonding region BB through two first-type second conductive patterns 172a.

In some other examples, b may take a value of 1. That is, the multiple second voltage lines 161 in the second voltage line group 160 are electrically connected to bonding pins in the bonding region BB through one first-type second conductive pattern 172a.

It can be understood that the value of a and the value of b can be the same or different.

In some embodiments, b is not greater than half of the number of the second voltage lines 161 in the second voltage line group 160.

It can be understood that b is not greater than half the number of the second voltage lines 161 in the second voltage line group 160, that is, b is less than or equal to half the number of the second voltage lines 161. Such an arrangement is able to reduce the number of the first-type second conductive pattern(s) 172a, thereby reducing the number of bonding pins electrically connected to the second voltage lines 161, and reducing the width of the flexible circuit board 105 along the first direction X, so as to lower the cost of the substrate 100.

In some examples, in a case where the value of b is small (e.g., the value of b is 1 or 2), the width of the first-type second conductive pattern 172a along the first direction X may be increased to enable the first-type second conductive pattern 172a to be bonded and connected to a larger number of bonding pins, so as to reduce the value of the current on the first-type second conductive pattern 172a, reduce the heat dissipation of the first-type second conductive pattern 172a, and improve the reliability of the substrate 100.

In some examples, the first-type first conductive pattern 171a and the first-type second conductive pattern 172a are arranged at intervals, so as to avoid localized overheating of the substrate 100 to improve the uniformity of the heat of the substrate 100 at different locations.

Referring again to FIG. 3A and FIG. 3B, it can be seen from the above that the substrate 100 includes a plurality of bridging parts 140. In some embodiments, the substrate 100 further includes multiple third bridging parts 143, and at least two first conductive patterns 171 are electrically connected together through a third bridging part 143.

It can be understood that two first conductive patterns 171 arranged at intervals along the first direction X may be electrically connected through a third bridging part 143, and two first conductive patterns 171 arranged at intervals along the second direction Y may also be electrically connected through a third bridging part 143.

By providing the third bridging parts 143, the first conductive patterns 171 arranged at intervals are able to be connected together through the third bridging parts 143, improving the wiring flexibility of the substrate 100.

It can be understood that the current-carrying capacity of the third bridging part 143 may be adjusted by adjusting the width, thickness, etc., of the third bridging part 143. In some examples, the third bridging part 143 may be set to have a relatively large width as well as a relatively large thickness to increase the current-carrying capacity of the third bridging part 143. In some other examples, the third bridging part 143 may be set to have a relatively small width as well as a relatively small thickness to meet different usage requirements.

In some examples, the insulating layer is further provided therein with fourth through holes each exposing a surface of a partial region of a first conductive pattern 171, and the third bridging part 143 is electrically connected to exposed surfaces of regions of at least two first conductive patterns 171.

In some embodiments, as shown in FIG. 3A and FIG. 3B, the substrate 100 further includes multiple fourth bridging parts 144, and at least two second conductive patterns 172 are electrically connected together through a fourth bridging part 144.

It can be understood that two second conductive patterns 172 arranged at intervals along the first direction X may be electrically connected through a fourth bridging part 144, and two second conductive patterns 172 arranged at intervals along the second direction Y may also be electrically connected through a fourth bridging part 144.

By providing the fourth bridging parts 144, second first conductive patterns 172 arranged at intervals are able to be connected together through the fourth bridging parts 144, improving the wiring flexibility of the substrate 100.

It can be understood that the current-carrying capacity of the fourth bridging part 144 may be adjusted by adjusting the width, thickness, etc., of the fourth bridging part 144. In some examples, the fourth bridging part 144 may be set to have a relatively large width as well as a relatively large thickness to increase the current-carrying capacity of the fourth bridging part 144. In some other examples, the fourth bridging part 144 may be set to have a relatively small width as well as a relatively small thickness to meet different usage requirements.

In some examples, the insulating layer is further provided therein with fifth through holes each exposing a surface of a partial region of a second conductive pattern 172, and the fourth bridging part 144 is electrically connected to exposed surfaces of regions of at least two second conductive patterns 172.

In some embodiments, in the same first voltage line group 150, at least two first voltage lines 151 are connected to each other on a side thereof away from the bonding region BB along the second direction Y.

It can be understood that arranging the at least two first voltage lines 151 to be connected to each other on the side thereof away from the bonding region BB along the second direction Y is able to reduce the voltage drop of the first voltage lines 151, conducive to reducing the width of the first voltage lines 151 along the first direction X, conducive to realizing the narrow bezel of the substrate 100, and further conducive to reducing the thickness of the first voltage lines 151, thereby lowering the cost of the substrate 100.

In some embodiments, in the same second voltage line group 160, at least two second voltage lines 161 are connected to each other on a side thereof away from the bonding region BB along the second direction Y.

It can be understood that arranging the at least two second voltage lines 161 to be connected to each other on the side thereof away from the bonding region BB along the second direction Y is able to reduce the voltage drop of second voltage lines 161, conducive to reducing the width of the second voltage lines 161 along the first direction X, conducive to realizing the narrow bezel of the substrate 100, and further conducive to reducing the thickness of the second voltage lines 161, thereby lowering the cost of the substrate 100.

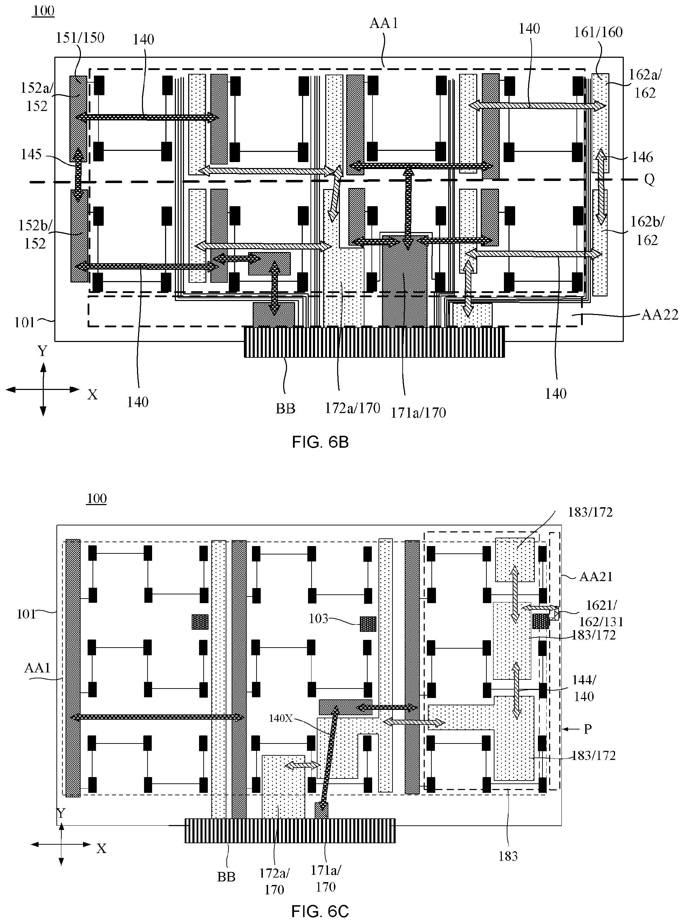

FIG. 6A is a structural diagram of a substrate in accordance with still yet some other embodiments. FIG. 6B is a structural diagram of a substrate in accordance with still yet some other embodiments. FIG. 6C is a structural diagram of a substrate in accordance with still yet some other embodiments.

As can be seen from the above, in some examples, at least two signal lines 131 in a signal line group 130 may be electrically connected together through a bridging part 140 and/or a conductive pattern 170.

In some other examples, as shown in FIG. 6A and FIG. 6B, at least two signal lines 131 in at least one signal line group 130 are electrically connected together through a bridging part 140.

For example, as shown in FIG. 6A and FIG. 6B, at least two signal lines 131 in at least one signal line group 130 may not be electrically connected together through a conductive pattern 170, but only through a bridging part 140. It can be understood that at least two signal lines 131 in a signal line group 130 are electrically connected together through a bridging part 140, the voltage drop of the signal lines 131 can be reduced, thereby conducive to reducing the width of the signal lines 131 along the first direction X, which is beneficial to realize the narrow frame of the substrate 100, and is also beneficial to reducing the thickness of the second voltage lines 161 to lower the cost of the substrate 100.

Moreover, in some examples, as shown in FIG. 6A and FIG. 6B, at least one bridging part 140 is located in the central region AA1, enabling at least two signal lines 131 in a signal line group 130 to be electrically connected together in the central region AA1 through the bridging part 140. As a result, it is made possible that the electrically connected signal lines 131 may share bonding pins in the bonding region BB to be electrically connected thereto. In this way, in an aspect, it makes it unnecessary for the signal lines 131 to extend along the first direction X in the lower edge region AA22, reduces the space occupied by the signal lines 131 in the lower edge region AA22, and is conducive to reducing the width of the lower edge region AA22, and thus is conducive to reducing the narrow frame of the substrate 100; and in another aspect, it is also possible to improve the ease of electrically connecting the signal lines 131 to the bonding pins, thereby improving the ease of the wiring of the substrate 100.

As can be seen from the above, in some examples, the first-type first conductive pattern(s) 171a is electrically connected to the first voltage line group 150, and the first-type second conductive pattern(s) 172a is electrically connected to the second voltage line group 160. In some examples, as shown in FIG. 6A and FIG. 6B, multiple first voltage lines 151 in the first voltage line group 150, after being electrically connected through bridging parts 140, are electrically connected to bonding pins through the first-type first conductive pattern(s) 171a; and multiple second voltage lines 161 in the second voltage line group 160, after being electrically connected through bridging parts 140, are electrically connected to bonding pins through the first-type second conductive pattern(s) 172a.

It can be understood that after the multiple first voltage lines 151 are electrically connected together, after being electrically connected to the bonding pins through the first-type first conductive pattern(s) 171a, the number of the bonding pins electrically connected to the multiple first voltage lines 151 may be reduced, thereby reducing the width of the flexible circuit board 105 along the first direction X and lowering the cost.

Similarly, after the multiple second voltage lines 161 are electrically connected together, after being electrically connected to the bonding pins through the first-type second conductive pattern(s) 172a, the number of the bonding pins electrically connected to the multiple second voltage lines 161 may be reduced, thereby reducing the width of the flexible circuit board 105 along the first direction X and lowering the cost.

In some examples, as shown in FIG. 6A, a bridging part 140 that electrically connects at least two signal lines 131 is located between two adjacent device groups 110 along the second direction Y. Such an arrangement enables the bridging part 140 to be located outside a region where the device groups 110 are located, which reduces the impact of the bridging part 140 on the light emission of electronic components 120 in the device groups 110 and improves the reliability of the substrate 100.

In some other examples, as shown in FIG. 6B, a bridging part 140 that electrically connects at least two signal lines 131 may overlap with a region where the device groups 110 are located, which improves the wiring flexibility of the substrate 100.

In some embodiments, as shown in FIG. 6B, at least one first voltage line 151 in the first voltage line group 150 includes at least two first sub-portions 152, and the at least two first sub-portions 152 are arranged at intervals along the second direction Y. The plurality of bridging parts 140 include multiple fifth bridging parts 145, and a fifth bridging part 145 is electrically connected to two adjacent first sub-portions 152 in the same first voltage line 151.

As shown in FIG. 6B, two adjacent first sub-portions 152 in the same first voltage line 151 are connected through the fifth bridging part 145. It can be understood that by adjusting the thickness and width of the fifth bridging part 145, the current carrying capacity of the fifth bridging part 145 can be adjusted. In some examples, the fifth bridging part 145 may be provided with a relatively large width as well as a relatively large thickness to increase the current carrying capacity of the fifth bridging part 145. In some other examples, the fifth bridging part 145 may be provided with a relatively small width as well as a relatively small thickness to meet different usage requirements.

It can be understood that the larger the current-carrying capacity of the fifth bridging part 145, the smaller the current-carrying capacity of the first sub-portion 152 may be set, which is beneficial for reducing the width of the first sub-portion 152 along the first direction X, which is beneficial for realizing the narrow frame of the substrate 100, and which is also beneficial for reducing the thickness of the first sub-portion 152, thereby beneficial for lowering the cost of the substrate 100.

In some examples, as shown in FIG. 6B, each first voltage line 151 in the first voltage line group 150 includes at least two first sub-portions 152. For example, at least one first sub-portion 152 of one first voltage line 151 may be electrically connected to a first sub-portion 152 of another first voltage line 151 through a bridging part 140.

In this way, first sub-portions 152 of different first voltage lines 151 are enabled to be electrically connected together, so that the voltage drop on the first sub-portions 152 may be reduced, which is conducive to reducing the width of the first sub-portions 152 along the first direction X, and is also conducive to reducing the thickness of the first sub-portions 152, and lowering the cost of the substrate 100.

In some examples, as shown in FIG. 6B, any first voltage line 151 includes two first sub-portions 152. For example, the two first sub-portions 152 include a 1^{st} first sub-portion 152a and a 2^{nd} first sub-portion 152b. The 1^{st} first sub-portion 152a and the 2^{nd} first sub-portion 152b are located along the second direction Y, on two sides of a center line Q of the central region AA1. It will be understood that the center line Q extends along the first direction X and is located at the center of the central region AA1 along the second direction Y.

It will be noted that the 1^{st} first sub-portion 152a and the 2^{nd} first sub-portion 152b are only used to differentiate the two different first sub-portions 152, without further limiting the first sub-portions 152.

In some examples, as shown in FIG. 6B, the 1^{st} first sub-portion 152a is further away from the bonding region BB relative to the 2^{nd} first sub-portion 152b.

In some examples, as shown in FIG. 6B, 1^{st} first sub-portions 152a of multiple first voltage lines 151 are electrically connected together through bridging parts 140, and 2^{nd} first sub-portions 152 of the multiple first voltage lines 151 are also electrically connected together through bridging parts 140. A 1st first sub-portion 152a of a first voltage line 151 among the first voltage lines 151 is electrically connected to a 2^{nd} first sub-portion 152a of this first voltage line 151 through a fifth bridging part 145.

For example, the 1^{st} first sub-portions 152a of the multiple first voltage lines 151 may, after being electrically connected together, be electrically connected to a conductive pattern 170 (e.g., a first-type first conductive pattern 171a) through the bridging parts 140; and the 2^{nd} first sub-portions 152b of the multiple first voltage lines 151 may also, after being electrically connected together, be electrically connected to a conductive pattern 170 (e.g., a first-type first conductive pattern 171a) through the bridging parts 140.

It can be understood that, the 1^{st} first sub-portion 152a and the 2^{nd} first sub-portion 152b are arranged to be located along the second direction Y, on both sides of the center line Q of the central region AA1, as well as the 1^{st} first sub-portions 152a of the multiple first voltage lines 151 are arranged to be electrically connected together, and the 2^{nd} first sub-portions 152b of the multiple first voltage lines 151 are arranged to be electrically connected together, in this way, the current on all first sub-portions 152 (including the 1^{st} first sub-portions 152a and the 2^{nd} first sub-portions 152b) may be reduced.

For example, for a first voltage line 151 including two first sub-portions 152, each of the first sub-portions 152 thereof carries a current value that is half of a current value needing to be carried by the single first voltage line 151. Since each first sub-portion 152 has a smaller current-carrying capacity, it is possible to reduce the design requirements (e.g., line width, line thickness, or material used) for the first sub-portion 152. In some examples, by the above-described arrangement, the thickness of the first sub-portions 152 included in the first voltage line 151 is enabled to be substantially thinner, reducing the amount of the material used and lowering the cost of the substrate 100.

In some embodiments, as shown in FIG. 6B, at least one second voltage line 161 in the second voltage line group 160 includes at least two second sub-portions 162, and the at least two second sub-portions 162 are arranged at intervals along the second direction Y. The plurality of bridging parts 140 include multiple sixth bridging parts 146, and a sixth bridging part 146 is electrically connected to two adjacent second sub-portions 162 in the same second voltage line 161.

As shown in FIG. 6B, two adjacent second sub-portions 162 in the same second voltage line 161 are connected through the sixth bridging part 146. It can be understood that by adjusting the thickness and width of the sixth bridging part 146, the current carrying capacity of the sixth bridging part 146 can be adjusted. In some examples, the sixth bridging part 146 may be provided with a relatively large width as well as a relatively large thickness to increase the current carrying capacity of the sixth bridging part 146. In some other examples, the sixth bridging part 146 may be provided with a relatively small width as well as a relatively small thickness to meet different usage requirements.

It can be understood that the larger the current-carrying capacity of the sixth bridging part 146, the smaller the current-carrying capacity of the first sub-portion 152 may be set, which is beneficial for reducing the width of the first sub-portion 152 along the first direction X, which is beneficial for realizing the narrow frame of the substrate 100, and which is also beneficial for reducing the thickness of the first sub-portion 152, thereby beneficial for lowering the cost of the substrate 100.

In some examples, as shown in FIG. 6B, each second voltage line 161 in the second voltage line group 162 includes at least two second sub-portions 162. For example, at least one second sub-portion 162 of one second voltage line 161 may be electrically connected to a second sub-portion 162 of another second voltage line 161 through a bridging part 140.

In this way, second sub-portions 162 of different second voltage lines 161 are enabled to be electrically connected together, so that the voltage drop on the second sub-portions 162 may be reduced, which is conducive to reducing the width of the first sub-portions 152 along the first direction X, and is also conducive to reducing the thickness of the first sub-portions 152, and lowering the cost of the substrate 100.

In some examples, as shown in FIG. 6B, any second voltage line 161 includes two second sub-portions 162. For example, the two second sub-portions 162 include a 1^{st} second sub-portion 162a and a 2^{nd} second sub-portion 162b. The 1^{st} second sub-portion 162a and the 2^{nd} second sub-portion 162b are located along the second direction Y, on two sides of a center line Q of the central region AA1.

It will be noted that the 1^{st} second sub-portion 162a and the 2^{nd} second sub-portion 162b are only used to differentiate the two different second sub-portions 162, without further limiting the second sub-portions 162.

In some examples, as shown in FIG. 6B, the 1^{st} second sub-portion 162a is further away from the bonding region BB relative to the 2^{nd} second sub-portion 162b.

In some examples, as shown in FIG. 6B, 1^{st} second sub-portions 162a of multiple second voltage lines 161 are electrically connected together through bridging parts 140, and 2^{nd} second sub-portions 162 of the multiple second voltage lines 161 are also electrically connected together through bridging parts 140. A 1^{st} second sub-portion 162a of a second voltage line 161 among the second voltage lines 161 is electrically connected to a 2^{nd} second sub-portion 162a of this second voltage line 161 through a sixth bridging part 146.

For example, the 1^{st} second sub-portions 162a of the multiple second voltage lines 161 may, after being electrically connected together, be electrically connected to a conductive pattern 170 (e.g., a first-type second conductive pattern 172a) through the bridging parts 140; and the 2^{nd} second sub-portions 162b of the multiple second voltage lines 161 may also, after being electrically connected together, be electrically connected to a conductive pattern 170 (e.g., a first-type second conductive pattern 172a) through the bridging parts 140.

It can be understood that, the 1^{st} second sub-portion 162a and the 2^{nd} second sub-portion 162b are arranged to be located along the second direction Y, on both sides of the center line Q of the central region AA1, as well as the 1^{st} second sub-portions 162a of the multiple second voltage lines 161 are arranged to be electrically connected together, and the 2^{nd} second sub-portions 162b of the multiple second voltage lines 161 are arranged to be electrically connected together, in this way, the current on all second sub-portions 162 (including the 1^{st} second sub-portions 162a and the 2^{nd} second sub-portions 162b) may be reduced.

For example, for a second voltage line 161 including two second sub-portions 162, each of the second sub-portions 162 thereof carries a current value that is half of a current value needing to be carried by the single second voltage line 161. Since each second sub-portion 162 has a smaller current-carrying capacity, it is possible to reduce the design requirements (e.g., line width, line thickness, or material used) for the second sub-portion 162. In some examples, by the above-described arrangement, the thickness of the second sub-portions 162 in the second voltage line 161 is enabled to be substantially thinner, reducing the amount of the material used and lowering the cost of the substrate 100.

In some embodiments, as shown in FIG. 6C, at least two second conductive patterns 172 arranged along the second direction Y form a second conductive pattern column 183. A second conductive pattern column 183 adjacent to an edge P of the base 101 along the first direction X overlaps with a region where a column of device groups 110 is arranged along the second direction Y.

It can be understood that as shown in FIG. 6C, the second conductive pattern column 183 includes multiple second conductive patterns 172. In some examples, as shown in FIG. 6C, any second conductive pattern 172 in the second conductive pattern column 183 is adjacent to the edge P of the base 101 along the first direction X.

The second conductive pattern column 183 overlaps with the region where the column of device groups 110 arranged along the second direction Y is located, that is, the multiple second conductive patterns 172 in the second conductive pattern column 183 are located in the region where the column of device groups 110 arranged along the second direction Y is located. It can be understood that the region where the column of device groups 110 is located includes a region each device group 110 in the column of device groups 110 is located, and a region between any two device groups 110 adjacent to each other along the second direction Y in the column of device groups 110.

It can be understood that setting the second conductive pattern column 183 to overlap with the region where the column of device groups 110 arranged along the second direction Y is located, is able to improve the area utilization rate of the base 101, enabling more device groups 110 to be arranged on the base 101.

In some examples, the second conductive pattern column 183 is located in a region where a column of device groups 110, which is adjacent to an edge P of the base 101 along the first direction X, is located. By such an arrangement, it is possible to reduce a distance between the multiple second conductive patterns 172 in the second conductive pattern column 183 and the edge P at a side of the base 101 along the first direction X, thereby reducing a distance between the second conductive pattern column 183 and the side edge region AA21, and improving the ease of electrically connecting a signal line 131 (e.g., a second voltage line 161) in the side edge region AA21 to the second conductive pattern column 183.

In some examples, as shown in FIG. 6C, the signal line 131 (e.g., the second voltage line 161) in the side edge region AA21 may be electrically connected to a bonding pin in the bonding region BB through the second conductive pattern column 183. That is, by providing the second conductive pattern column 183, the signal line 131 in the side edge region AA21 does not need to extend into the lower edge region AA22, which is conducive to reducing the width of the lower edge region AA22, and thus facilitates realizing the narrow frame (lower frame) of the substrate 100.

In some examples, as shown in FIG. 6C, the first driving chip 103 is located in the central region AA1, and the second voltage line 161 extends into the central region AA1 to electrically connect to the first driving chip 103. Such an arrangement makes it unnecessary for the first driving chip 103 to occupy the space of the side edge region AA21, which is conducive to reducing the width of the side edge region AA21 along the first direction X, and thus facilitates realizing the narrow frame of the substrate 100.

In some examples, in a case where a column of device groups 110 is electrically connected to multiple first driving chips 103, as shown in FIG. 6C, the second voltage line 161 includes multiple sub-line segments 1621, the multiple sub-line segments 1621 arranged at intervals along the second direction Y, and a sub-line segment 1621 is electrically connected to a first driving chip 103.

It can be understood that the bridging part 140 may be angled with the first direction X or the second direction Y. As shown in FIG. 6C, a bridging part 140X is neither parallel to the first direction X nor to the second direction Y.

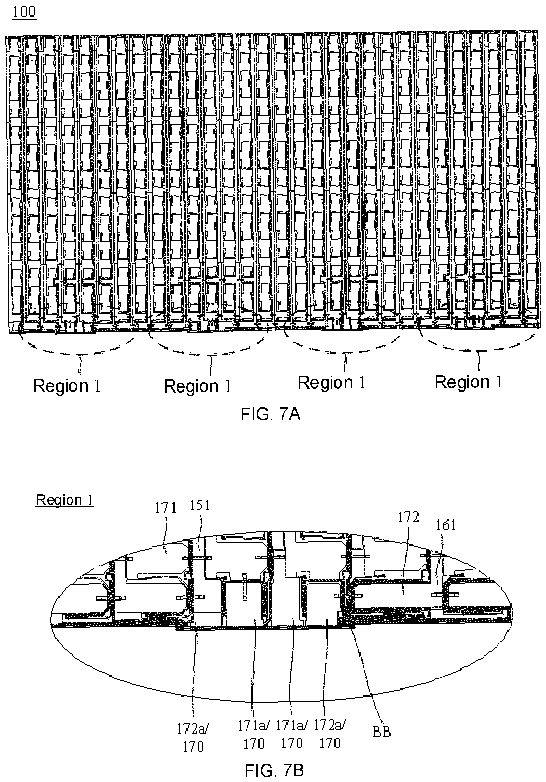

FIG. 7A is a structural diagram of a substrate in accordance with still yet some other embodiments. FIG. 7B is a partially enlarged view of the region 1 in FIG. 7A.

As can be seen from the above, in some examples, by providing the conductive pattern 170 and the bridging part 140, multiple signal lines 131 in a signal line group 130 may be electrically connected together, and by compensating for the conductive pattern 170, it may serve to reduce the voltage drop of the signal line 131.

In some examples, the device region AA is divided into P regions along the first direction X. The P regions are arranged sequentially along the first direction X, with at least two columns of device groups 110 disposed in each region. It can be understood that the number of columns of device groups 110 in different regions may be the same or may be different. In some examples, an absolute value of a difference in the numbers of columns of device groups 110 in any two regions is less than or equal to 2.

It can be understood that one region corresponds to one bonding region BB. In some examples, as shown in FIG. 7A and FIG. 7B, the substrate 100 has four bonding regions BB, that is, the device group AA may be divided into four regions (P=4) along the first direction X.

It can be understood that at least two columns of device groups 110 belonging to the same region are connected to the same bonding region BB. For example, in the same region, multiple signal line groups 130 connected to one bonding region BB include a first voltage line group 150 and a second voltage line group 160.

For example, taking any region in the device region AA as an example, at least two first voltage lines 151 in the first voltage line group 150, after being electrically connected together through a second-type first conductive pattern 171b located in the device group AA, are then electrically connected together through two first-type first conductive patterns 171a to a bonding pin in a bonding region BB; and at least two second voltage lines 161 in the second voltage line group 160, after being electrically connected together through a second-type second conductive pattern 172b located in the device group AA, are then electrically connected together through two first-type second conductive patterns 172a to a bonding pin in a bonding region BB.

It can be understood that since the number of bonding regions BB is four, four flexible circuit boards 105 are required to be electrically connected to these bonding regions BB. That is, a larger number of bonding regions BB increases the number of flexible circuit boards 105, thereby increasing the cost.

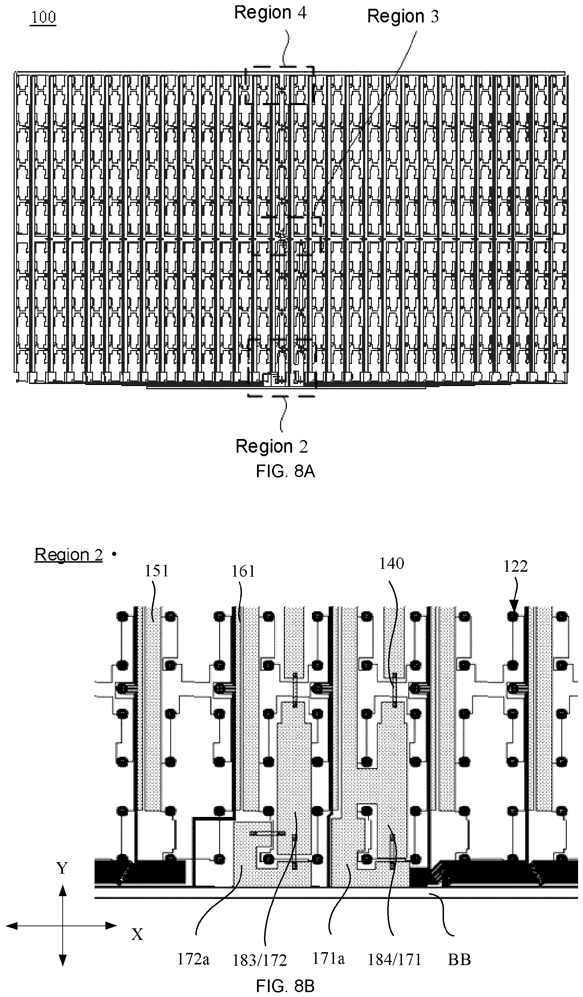

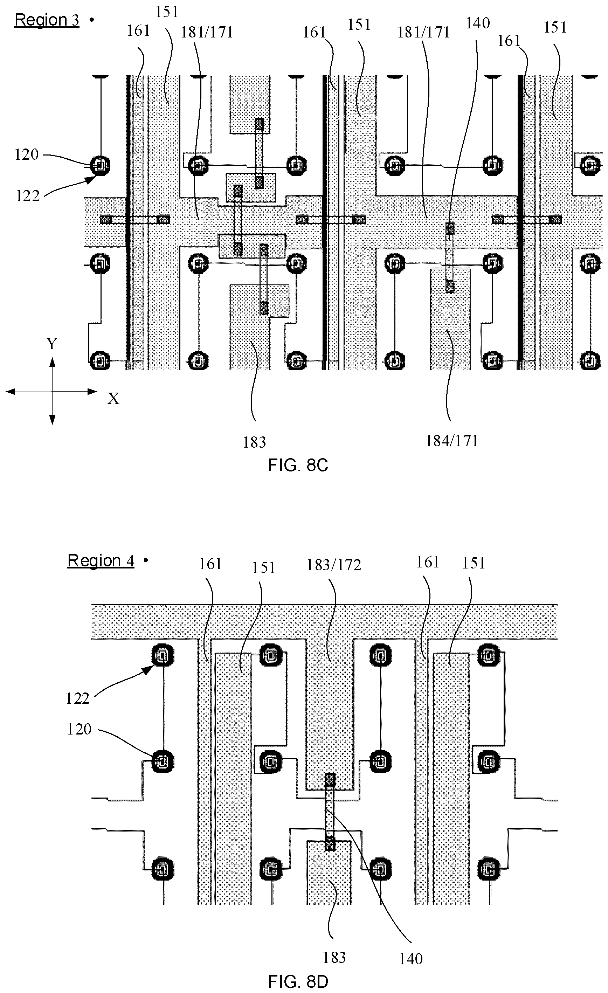

FIG. 8A is a structural diagram of a substrate in accordance with still yet some other embodiments. FIG. 8B is a partially enlarged view of the region 2 in FIG. 8A. FIG. 8C is a partially enlarged view of the region 3 in FIG. 8A. FIG. 8D is a partially enlarged view of the region 4 in FIG. 8A.

Based on this, in some embodiments, as shown in FIG. 8A and FIG. 8B, the substrate 100 is provided with only one bonding region BB. In some examples, a center line of the bonding region BB along the second direction Y coincides with a center line of a device group AA along the second direction Y.

It can be understood that since the substrate 100 is provided with only one bonding region BB, in this way, the signal lines 131 in the plurality of signal line groups 130 (including the first voltage line group 150 and the second voltage line group 160) need to be electrically connected to the bonding pins in the same bonding region BB.

It can be understood that the only one bonding region BB is able to reduce the number of flexible circuit boards 105, thereby lowering the cost.

The following is an example of the manner in which the first voltage line group 150 and the second voltage line group 160 are electrically connected to the bonding region BB.

As can be seen from the above, at least two first conductive patterns 171 arranged along the first direction X form a first conductive pattern row 181. It can be understood that in some examples, there may be two first conductive pattern rows 181. In some other examples, there may be one first conductive pattern row 181. The embodiments of the present disclosure illustrate, by way of example in which there is one first conductive pattern row 181, the electrical connection relationship between the first voltage line group 150 and the bonding region BB.

In some examples, as shown in FIG. 8B and FIG. 8C, at least two first conductive patterns 171 arranged along the second direction Y form a first conductive pattern column 184. As shown in FIG. 8C, the first conductive pattern row 181 is electrically connected to the first conductive pattern column 184, and as shown in FIG. 8B, the first-type first conductive pattern 171a is electrically connected to the first conductive pattern column 184. It can be understood that the first conductive pattern row 181 and the first conductive pattern column 184 may be located in the central region AA1 of the device region AA to avoid the first conductive pattern row 181 and the first conductive pattern column 184 from occupying the space of the edge regions AA2 (including the side edge region AA21 and the lower edge region AA22), which is beneficial for realizing the narrow frame of the substrate 100.

In some examples, as shown in FIG. 8C, the multiple first voltage lines 151 in the first voltage line group 150 are able to be electrically connected through the first conductive pattern row 181. One first conductive pattern 171 in the first conductive pattern row 184 is electrically connected to the first conductive pattern row 181 through a bridging part 140. As shown in FIG. 8B, another first conductive pattern 171 in the first conductive pattern row 184 is electrically connected to the first-type first conductive pattern 171a through a bridging part 140, so that the multiple first voltage lines 151 after being electrically connected in the first voltage line group 150 are able to be electrically connected to the bonding pins.

It can be understood that since multiple first conductive patterns 171 in multiple first conductive pattern columns 184 are arranged in one column along the second direction Y, the multiple first voltage lines 151, after being electrically connected, are able to be electrically connected to the bonding pins in the one bonding region BB, through the first-type first conductive patterns 171a. That is, the multiple first voltage lines 151 are able to be electrically connected to the bonding pins in the one bonding region BB by providing the first conductive pattern row 181 and the first conductive pattern column 184.

In this way, the number of flexible circuit boards 105 bonded and connected to the bonding pins may be reduced, thereby lowering the cost of the substrate 100.

In some examples, the first conductive pattern column 184 is electrically connected to the bonding pin through a first-type first conductive pattern 171a, reducing the number of the first-type first conductive patterns 171a, and the number of the bonding pins electrically connected to the first voltage lines 151, thereby reducing the width of the flexible circuit board 105 along the first direction X, and lowering the cost of the substrate 100.

That is, by providing the first conductive pattern row 181 and the first conductive pattern column 184, it is made possible to reduce the number of the bonding regions BB of the substrate 100 on the basis of realizing the narrow frame and to reduce the number of the bonding pins of the substrate 100 electrically connected to the first voltage line group 150, thereby reducing the cost.

In addition, arranging the multiple first voltage lines 151 electrically connected, through the first conductive pattern column 184, to the bonding pins in the bonding region BB is also able to reduce the number of the bridging parts 140, thereby simplifying the process of manufacturing the substrate 100, improving the manufacturing efficiency of the substrate 100, and lowering the cost.

In some embodiments, the first conductive pattern row 181 is located at the center of the device region AA along the second direction Y.

It can be understood that arranging the first conductive pattern row 181 to be located at the center of the device region AA along the second direction Y enables the multiple first voltage lines 151 to be electrically connected at the center position along the second direction Y. In this way, the first voltage lines 151 are required to carry a current whose value is half of a value of a current that the first voltage lines 151 are required to carry in a case where the first conductive pattern row 181 is not provided.

That is, arranging the first conductive pattern row 181 to be located at the center of the device region AA along the second direction Y is able to reduce the value of the current to be carried by the first voltage lines 151, reduce the risk of overloading of the first voltage lines 151, and improve the reliability of the substrate 100. In addition, it is also possible to facilitate the thinning of the first voltage lines 151 and reduce the cost of the substrate 100.

In some examples, arranging the first conductive pattern row 181 to be located at the center of the device region AA along the second direction Y enables the thickness of the first voltage lines 151 to be reduced to half of the thickness of the first voltage lines 151 in a case where the first conductive pattern row 181 is not provided.

As can be seen from the above, in some embodiments, as shown in FIG. 8D, multiple second voltage lines 161 in a second voltage line group 160 are connected to each other on a side thereof along the second direction Y away from the bonding region BB. In addition, at least two second conductive patterns 172 arranged along the second direction Y form a second conductive pattern column 183.

In some embodiments, as shown in FIG. 8B and FIG. 8D, the second conductive pattern column 183 is electrically connected to the side of the multiple second voltage lines 161 in the second voltage line group 160 that is away from the bonding region BB, and a first-type second conductive pattern 172a is electrically connected to the second conductive pattern column 183. It can be understood that the multiple second voltage lines 161 in the second voltage line group 160 being connected to each other on the side thereof along the second direction Y away from the bonding region BB enables the multiple second voltage lines 161 in the second voltage line group 160 to be electrically connected together.

As shown in FIG. 8B and FIG. 8D, one second conductive pattern 172 in the second conductive pattern column 183 is electrically connected to ends of multiple second voltage lines 161 away from the bonding region BB. As shown in FIG. 8B, another second conductive pattern 172 in the second conductive pattern column 183 is electrically connected to the first-type second conductive pattern 172a, enabling the multiple second voltage lines 161 to be electrically connected to the bonding pins through the second conductive pattern column 183.

It can be understood that since multiple second conductive patterns 172 in multiple second conductive pattern columns 183 are arranged in one column along the second direction Y, the multiple second voltage lines 161, after being electrically connected, are able to be electrically connected to the bonding pins in the one bonding region BB, through the first-type second conductive patterns 172a. That is, the multiple second voltage lines 161 are able to be electrically connected to the bonding pins in the one bonding region BB by providing the second conductive pattern column 183.

In this way, the number of flexible circuit boards 105 bonded and connected to the bonding pins may be reduced, thereby lowering the cost of the substrate 100.

In some examples, the second conductive pattern column 183 is electrically connected to the bonding pin through a first-type second conductive pattern 172a, reducing the number of the first-type second conductive patterns 172a, and the number of the bonding pins electrically connected to the second voltage lines 161, thereby reducing the width of the flexible circuit board 105 along the first direction X, and lowering the cost of the substrate 100.

That is, by providing the second conductive pattern column 183, it is made possible to reduce the number of the bonding regions BB of the substrate 100 on the basis of realizing the narrow frame and to reduce the number of the bonding pins of the substrate 100 electrically connected to the second voltage line groups 160, thereby reducing the cost.

In addition, arranging the multiple second voltage lines 161 electrically connected, through the second conductive pattern column 183, to the bonding pins in the bonding region BB is also able to reduce the number of the bridging parts 140, thereby simplifying the process of manufacturing the substrate 100, improving the manufacturing efficiency of the substrate 100, and lowering the cost.

It can be understood that multiple second voltage lines 161 in a second voltage line group 160 extend along the second direction Y, and a second voltage line 161 is located on a second side of a column of device groups 110 electrically connected to this second voltage line 161, and the multiple second voltage lines 161 do not extend to the lower edge region AA22, but are connected to each other on a side thereof along the second direction Y away from the bonding region BB. Thereby, the second conductive pattern column 183 is enabled to be electrically connected to the multiple second voltage lines 161 on the side thereof along the second direction Y away from the bonding region BB.

That is, in the embodiments of the present disclosure, the multiple second voltage lines 161 in the second voltage line group 160 may be connected to each other on the side thereof along the second direction Y away from the bonding region BB, and electrically connected to the bonding pins through the second conductive pattern column 183.

It can be understood that the multiple second voltage lines 161 in the second voltage line group 160 are connected to each other on the side thereof along the second direction Y away from the bonding region BB, increasing the area of orthographic projections of conductive structures (the plurality of signal line groups 130 and the plurality of conductive patterns 170) in the conductive layer on the base 101. For example, in a case where a material of the conductive layer is Cu, the multiple second voltage lines 161 in the second voltage line group 160 being connected to each other on the side thereof along the second direction Y away from the bonding region BB is able to increase a ratio of the area of Cu in the conductive layer to the area of the base 101, and is able to increase the electro static discharge (ESD) capability of the substrate 100, improving the reliability of the substrate 100.

In some examples, as shown in FIG. 8B to FIG. 8D, the substrate 100 further includes encapsulation parts 122. An encapsulation part 122 is disposed on a side of an electronic component 120 away from the base 101 and encases this electronic component 120.

It can be understood that the encapsulation part 122 is able to play a role in protecting the electronic component 120, in an aspect, to avoid erosion of the electronic component 120 by external water or oxygen, etc., in another aspect, to reduce the risk that the electronic component 120 will be cut off by the cuts and fall under the action of an external force, to prolong the service life of the electronic component 120, and to improve the reliability of the substrate 100.

In some examples, in a case where the electronic component 120 is a light-emitting diode, the encapsulation part 122 encasing the light-emitting diode is made of a transparent material (for example, it may be made of a transparent silicone) to minimize blockage of light by the encapsulation part 122; and in a case where the electronic component 120 is not a light-emitting component or light-sensitive component, the encapsulation part 122 may be made of a non-transparent material.

In some examples, the encapsulation part 122 may be mushroom-shaped or nearly mushroom-shaped. It can be understood that encapsulation parts 122 encasing different electronic components 120 may have the same or different shapes.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A substrate, having multiple edges; the substrate comprising a device region and at least one bonding region, the bonding region being closer to any edge of the substrate relative to the device region; the substrate comprising:
a base;
a plurality of device groups, located on a side of the base, wherein the plurality of device groups are located in the device region, and the plurality of device groups are arranged along both a first direction and a second direction, the first direction intersecting the second direction, and the first direction and the second direction being parallel to the base; and a device group includes at least one electronic component;
a plurality of signal line groups, located on the same side of the base as the plurality of device groups, wherein a signal line group includes multiple signal lines, the multiple signal lines all extend along the second direction, and the multiple signal lines are arranged at intervals along the first direction; any signal line extends from a bonding region to the device region, and any signal line is electrically connected to a column of device groups arranged along the second direction; and
a plurality of bridging parts, located on the same side of the base as the plurality of device groups, wherein at least one bridging part is located in the device region;
wherein at least two signal lines in at least one signal line group are electrically connected together through a bridging part.

2. The substrate according to claim 1, wherein the plurality of signal line groups include:
a first voltage line group, the first voltage line group including multiple first voltage lines, wherein
at least one first voltage line in the first voltage line group includes at least two first sub-portions, and the at least two first sub-portions are arranged at intervals along the second direction; and
the plurality of bridging parts include multiple fifth bridging parts, and a fifth bridging part is electrically connected to two adjacent first sub-portions in a same first voltage line.

3. The substrate according to claim 2, wherein the plurality of signal line groups include:
a second voltage line group, the second voltage line group including multiple second voltage lines, wherein
at least one second voltage line in the second voltage line group includes at least two second sub-portions, and the at least two second sub-portions are arranged at intervals along the second direction; and
the plurality of bridging parts include multiple sixth bridging parts, and a sixth bridging part is electrically connected to two adjacent second sub-portions in a same second voltage line.

4. The substrate according to claim 3, further comprising:
a plurality of conductive patterns, wherein at least one conductive pattern in the plurality of conductive patterns is located in a region where a device group is located, and/or at least one conductive pattern in the plurality of conductive patterns is located in a region between two adjacent device groups;
wherein at least one signal line in at least one signal line group is electrically connected to a conductive pattern of the plurality of conductive patterns.

5. The substrate according to claim 4, wherein the at least one signal line in the at least one signal line group is electrically connected to the bonding region through the conductive pattern.

6. The substrate according to claim 5, wherein the plurality of conductive patterns include multiple first conductive patterns, and the multiple first conductive patterns are each electrically connected to at least one first voltage line in the first voltage line group.

7. The substrate according to claim 6, wherein the plurality of bridging parts include:
multiple first bridging parts, wherein at least one first conductive pattern is electrically connected to a first voltage line through a first bridging part.

8. The substrate according to claim 6 or 7, wherein at least one first conductive pattern and a first voltage line form a one-piece structure.

9. The substrate according to any one of claims 6 to 8, wherein at least two of the first conductive patterns are arranged along the first direction.

10. The substrate according to any one of claims 6 to 9, wherein the multiple first conductive patterns include first-type first conductive pattern(s), wherein
one end of a first-type first conductive pattern is directly connected to an end of the bonding region proximate to the device region, and the other end of the first-type first conductive pattern is electrically connected to the first voltage line group; and
a number of the first-type first conductive pattern(s) is a, a is less than a number of the first voltage lines in the first voltage line group, and a is a positive integer.

11. The substrate according to claim 10, wherein the a is not greater than half of the number of the first voltage lines in the first voltage line group.

12. The substrate according to claim 10 or 11, wherein at least two, arranged along the first direction, of the first conductive patterns form a first conductive pattern row; and at least two, arranged along the second direction, of the first conductive patterns form a first conductive pattern column; and
the first conductive pattern row is electrically connected to the first conductive pattern column, and the first-type first conductive pattern is electrically connected to the first conductive pattern column.

13. The substrate according to claim 12, wherein the first conductive pattern row is located at a center of the device region along the second direction.

14. The substrate according to any one of claims 6 to 13, wherein the plurality of conductive patterns include multiple second conductive patterns, and the multiple second conductive patterns are each electrically connected to at least one second voltage line in the second voltage line group.

15. The substrate according to claim 14, wherein the plurality of bridging parts further include:
multiple second bridging parts, wherein at least one second conductive pattern is electrically connected to a second voltage line through a second bridging part.

16. The substrate according to claim 14 or 15, wherein at least one second conductive pattern and a second voltage line form a one-piece structure.

17. The substrate according to any one of claims 14 to 16, wherein at least two of the second conductive patterns are arranged along the first direction.

18. The substrate according to any one of claims 14 to 17, wherein the plurality of second conductive patterns include first-type second conductive pattern(s), wherein
one end of a first-type second conductive pattern is directly connected to an end of the bonding region proximate to the device region, and the other end of the first-type second conductive pattern is electrically connected to the second voltage line group; and
a number of the first-type second conductive pattern(s) is b, b is less than a number of the second voltage lines in the first voltage line group, and b is a positive integer.

19. The substrate according to claim 18, wherein the b is not greater than half of the number of the second voltage lines in the second voltage line group.

20. The substrate according to claim 18 or 19, wherein the multiple second voltage lines in the second voltage line group are connected to each other on a side thereof away from the bonding region along the second direction; and
at least two, arranged along the second direction, of the second conductive patterns form a second conductive pattern column; and the second conductive pattern column is electrically connected to the side, away from the bonding region, of the multiple second voltage lines in the second voltage line group, and the first-type second conductive pattern is electrically connected to the second conductive pattern column.

21. The substrate according to any one of claims 14 to 20, wherein at least two, arranged along the second direction, of the second conductive patterns form a second conductive pattern column; and the second conductive pattern column, adjacent to an edge of the base along the first direction, overlaps with a region where a column of device groups arranged along the second direction is located.

22. The substrate according to any one of claims 14 to 21, wherein the plurality of bridging parts further include:
multiple third bridging parts, at least two of the first conductive patterns being electrically connected together through a third bridging part; and/or
multiple fourth bridging parts, at least two of the second conductive patterns being electrically connected together through a fourth bridging part.

23. The substrate according to any one of claims 14 to 22, wherein a first voltage line electrically connected to a column of device groups, and a second voltage line electrically connected to the column of device groups are arranged at intervals along the first direction.

24. The substrate according to claim 23, wherein any first voltage line is located, along the first direction, on a first side of a column of device groups electrically connected to the first voltage line; and any second voltage line is located, along the first direction, on a second side of a column of device groups electrically connected to the second voltage line.

25. The substrate according to any one of claims 3 to 24, wherein a width of the first voltage line along the first direction takes a value in a range of 0.5 mm to 1 mm; and/or a width of the second voltage line along the first direction takes a value in a range of 0.5 mm to 1 mm.

26. The substrate according to any one of claims 2 to 25, wherein the plurality of conductive patterns disposed in a same layer as the plurality of signal line groups.

27. The substrate according to any one of claims 1 to 26, wherein at least one of the plurality of bridging parts is a jumper resistor.

28. The substrate according to any one of claims 1 to 27, further comprising:
an electrostatic loop, disposed around the plurality of device groups and electrically connected to the bonding region; and
a circuit board, electrically connected to the bonding region.

29. An electronic apparatus, comprising the substrate according to any one of claims 1 to 28.
